# EUROPÄISCHE PATENTSCHRIFT

(11) **EP 2 831 309 B1**
(45) Veröffentlichungstag und Bekanntmachung des Hinweises auf die Patenterteilung: **18.01.2017**
(21) Anmeldenummer: 13710838.7
(22) Anmeldetag: 15.03.2013
(51) Int. Cl.: C25B 1/04, C25B 9/10, C25B 11/03, C25B 11/04, H01L 31/0725, C25B 1/00, C25B 1/10, C25B 9/08, H01L 31/076

(54) **PHOTOELEKTROCHEMISCHE ZELLE, SYSTEM UND VERFAHREN ZUR LICHTGETRIEBENEN ERZEUGUNG VON WASSERSTOFF UND SAUERSTOFF MIT EINER PHOTOELEKTROCHEMISCHEN ZELLE UND VERFAHREN ZUR HERSTELLUNG DER PHOTOELEKTROCHEMISCHEN ZELLE**
PHOTOELECTROCHEMICAL CELL, SYSTEM AND PROCESS FOR LIGHT-DRIVEN PRODUCTION OF HYDROGEN AND OXYGEN WITH A PHOTOELECTROCHEMICAL CELL, AND PROCESS FOR PRODUCING THE PHOTOELECTROCHEMICAL CELL
CELLULE PHOTOÉLECTROCHIMIQUE, SYSTÈME ET PROCÉDÉ DE PRODUCTION D'HYDROGÈNE ET D'OXYGÈNE PAR EXPOSITION D'UNE CELLULE PHOTOÉLECTROCHIMIQUE À LA LUMIÈRE, ET PROCÉDÉ DE FABRICATION DE LADITE CELLULE PHOTOÉLECTROCHIMIQUE

(30) Priorität: 30.03.2012 DE 102012205258
(43) Veröffentlichungstag der Anmeldung: 04.02.2015
(73) Patentinhaber: Evonik Degussa GmbH, 45128 Essen (DE)
(72) Erfinder: HOCH,Sachsa, 44797 Bochum (DE); BLUG, Matthias, 58455 Witten (DE); BUSSE Jens, 44879 Bochum (DE); CALVET, Wolfram, 12524 Berlin (DE); KAISER, Bernhard, 64285 Darmstadt (DE); JAEGERMANN, Wolfram, 64813 Groß-Umstadt-Kleestadt (DE); HAHN, Hanna, 47199 Duisburg-Baerl (DE); ZANTHOFF, Horst-Werner, 45481 Mülheim a.d. Ruhr (DE)
(86) Internationale Anmeldenummer: PCT/EP2013/055416
(87) Internationale Veröffentlichungsnummer: WO 2013/143885

(56) Entgegenhaltungen:
- US-A1- 2005 205 128
- US-A1- 2007 246 370
- PEHARZ ET AL: "Solar hydrogen production by water splitting with a conversion efficiency of 18%", INTERNATIONAL JOURNAL OF HYDROGEN ENERGY, ELSEVIER SCIENCE PUBLISHERS B.V., BARKING, GB, Bd. 32, Nr. 15, 27. Juni 2007 (2007-06-27) , Seiten 3248-3252, XP022300504, ISSN: 0360-3199, DOI: 10.1016/J.IJHYDENE.2007.04.036
- KHASELEV O ET AL: "High-efficiency integrated multijunction photovoltaic/electrolysis systems for hydrogen production", INTERNATIONAL JOURNAL OF HYDROGEN ENERGY, ELSEVIER SCIENCE PUBLISHERS B.V., BARKING, GB, Bd. 26, Nr. 2, 1. Februar 2001 (2001-02-01), Seiten 127-132, XP004312324, ISSN: 0360-3199, DOI: 10.1016/S0360-3199(00)00039-2 in der Anmeldung erwähnt

## Beschreibung

Die Erfindung betrifft eine photoelektrochemische Zelle zur Erzeugung von Wasserstoff und Sauerstoff, insbesondere aus Wasser oder einem anderen auf wässriger Lösung basierenden Elektrolyten. Die Erfindung betrifft auch ein System mit einer Vielzahl von solchen photoelektrochemischen Zellen mit wenigstens einer ersten und einer zweiten Zelle. Die Erfindung betrifft auch ein Verfahren zur lichtgetriebenen Erzeugung von Wasserstoff und Sauerstoff, insbesondere aus Wasser oder einem anderen auf wässriger Lösung basierenden Elektrolyten mit einer photoelektrochemischen Zelle. Die Erfindung betrifft auch ein Verfahren zur Herstellung einer photoelektrochemischen Zelle.

Die Herstellung von Wasserstoff erfolgt großtechnisch üblicherweise über den Prozess der Dampfreformierung, bei dem aus Kohlenwasserstoffen wie Erdgas, Erdöl, Biomasse etc. in zwei Prozessschritten Wasserstoff erzeugt wird. Die Kosten für diesen Prozess sind relativ hoch und stark an die allgemeinen Energiepreise gekoppelt. Außerdem entsteht in großen Mengen das klimaschädliche Gas CO₂. Für die Nutzung von Wasserstoff als regenerativ erzeugten Brennstoff ist es daher erforderlich, in Zukunft konkurrenzfähige Anlagen zu entwickeln. Die direkte photoelektrochemische Erzeugung von Wasserstoff stellt dafür eine technisch höchst interessante Variante dar. Mit einer lichtgetriebenen Erzeugung von Wasserstoff und Sauerstoff aus Wasser oder einem anderen auf wässriger Lösung basierenden Elektrolyten unter Nutzung einer photoelektrochemischen Zelle können die Kosten für eine Erzeugung von Wasserstoff konkurrenzfähig zu den momentan eingesetzten Methoden werden. Außerdem ist die Herstellung von Wasserstoff mit einer photoelektrochemischen Zelle nahezu klimaneutral, d. h. es entsteht kaum zusätzliches CO₂ während des Prozesses. Konkret kann mit Hilfe von solarerzeugtem Wasserstoff solare Energie in chemische Energie umgewandelt und so in eine besser speicherbare Form gebracht werden. Eine Umsetzung mittels einer photoelektrochemischen Zelle erlaubt die großtechnische Anwendung und - -mit der Erzeugung von Wasserstoff-- werden Probleme fluktuierender Energiebereitstellung gelöst, welche regenerative Energieerzeugungsformen aufweisen. Die Verwendung von photoelektrochemischen Zellen gilt als ökologisch sinnvoll, denn die Verbrennung von Wasserstoff mit Sauerstoff zu Wasser ist klimaneutral und umweltverträglich.

Es existieren inzwischen gute Kenntnisse über eine elektrochemische Erzeugung von Wasserstoff mit direkter Konversion wie zum Beispiel in WO 2005/007932 A2 dargelegt. Es gibt einfache Ansätze zur Kopplung von photovoltaischen und elektrochemischen Systemen wie zum Beispiel in DE 10 2004 050 638 B3 beschrieben. Grundsätzliche Voraussetzungen zur großtechnischen Darstellung von Dünnschicht-Solarzellen auf einem großflächigen Substrat zur Gewinnung von elektrischer Energie sind u. a. von Pijpers et al in PNAS Early Edition, Seiten 1 bis 6 unter www.pnas.org/cgi/doi/10.1073/pnas.1106545108 "Light-induced water oxidation at silicon electrodes functionalized with a cobalt oxigen-evolving catalyst." berücksichtigt. Die Artikel von Khaselev et al in SCIENCE Vol. 280, Seiten 425 bis 427 und International Journal of Hydrogen Energy 26 (2001), Seiten 127 bis 132 zeigen einen weiteren Ansatz zur Darstellung von photoelektrochemischen Systemen, etwa für eine III-V Tandemzelle oder Silizium-basierte Tripelzelle mit elektroplatierter Platinumelektrode als Gegenelektrode.

Auch aus US2005205128A1 ist die Integration einer Solarzelle und eines PEM-Elektrolyseurs bekannt. In dieser Schrift wird einzig Wasser als Elektrolyt, d.h. pH = 7 besprochen. Um die fehlende Ionenleitfähigkeit des reinen Wassers auszugleichen, wird eine saure Membran mit ionenleitenden Eigenschaften (Nafion®) verwendet. Das aus US2005205128A1 gezeigte System arbeitet also im sauren Milieu mit einem Festkörper-Elektrolyten.

Die Forschungsgruppe um Gerhard Peharz stellt in "Solar hydrogen production by water splitting with a conversion efficiency of 18%" (International Journal of Hydrogen Energy Bd. 32, Nr. 15, Seiten 3248-3252) ebenfalls eine photoelektrochemische Zelle mit einem Festkörper-Elektrolyten vor, der in reinem Wasser eingesetzt wird.

Gleichwohl mangelt es allen Systemen an einer ausreichenden Effizienz, die letztlich in der noch verbesserungswürdigen Integration der elektrochemischen Zelle begründet liegt. Während das Problem vergleichsweise dünner und stabiler Lichtabsorber in Photovoltaikzellen an den physikalischen Grenzen lösbar scheint, bestehen gleichwohl erhebliche Probleme zur effektiven elektronischen Kopplung zwischen dem festen Lichtabsorber und dem flüssigem Elektrolyten in einer elektrochemischen Zelle, d. h. an der koppelnden Grenze zwischen Photovoltaikzelle und Elektrochemiezelle. Auch ist der Ladungstransport zwischen dem Lichtabsorber und dem auf dem Elektrolyten basierenden Redox-System einer Elektrochemiezelle noch verbesserungswürdig. Alle bisher bekannten Systeme setzen die Elektrochemiezelle und die Photovoltaikzelle allseitig dem meist sauren Elektrolyten aus, was zu nicht unerheblichen Stabilitätsproblemen jedenfalls der Photovoltaikzelle führt. Auch zeigt sich, dass die angesprochenen Ankopplungen zwischen fester Photovoltaikzelle und teilweise flüssigem Elektrolyten der Elektrochemiezelle schwierig ist; dies führt zu hohen Widerständen am Eingang wenigstens der Elektrochemiezelle, was die Wirkungsgrade der gesamten photoelektrochemischen Zelle deutlich unter 10 % senkt.

Wünschenswert wäre eine verbesserte Systemlösung für die photoelektrochemische Zelle, welche nicht nur die Photovoltaikzelle und Teile der Elektrochemiezelle sondern alle Komponenten der Photovoltaikzelle und der Elektrochemiezelle umfasst, insbesondere den Elektrolyten berücksichtigt.

An dieser Stelle setzt die Erfindung an, deren Aufgabe es ist, eine Vorrichtung und ein Verfahren zur lichtgetriebenen Erzeugung von Wasserstoff und Sauerstoff aus Wasser oder einem anderen auf wässriger Lösung basierenden Elektrolyten anzugeben. Es soll insbesondere eine photoelektrochemische Zelle in einer verbesserten Bauweise zur Verfügung gestellt werden, die alle Komponenten, insbesondere eine Photovoltaikzelle und eine Elektrochemiezelle, vorzugsweise auch den Elektrolyten, mit umfasst. Insbesondere soll die photoelektrochemische Zelle für eine großtechnische Produktion geeignet sein, vorzugsweise vergleichsweise einfach aufgebaut und herstellbar sein; die Zelle sollte sowie möglichst nachhaltig, beständig und langlebig sein. Insbesondere sollten schädliche Einflüsse des Elektrolyten auf die photoelektrochemische Zelle, wie Korrosion oder dergleichen, herabgesetzt werden. Insbesondere sollten Absorbereigenschaften der Photovoltaikzelle unbeeinflusst von Einflüssen des Wassers oder anderer wässriger Elektrolyten verbesserbar sein. Insbesondere sollte der elektronische Gesamtwiderstand der photoelektrochemischen Zelle verringert sein. Vorzugsweise betrifft dies nicht nur eine Photovoltaikzelle mit verringertem Widerstand sondern vor allem eine effizienzoptimierte elektronische Kopplung zwischen Photovoltaikzelle und elektrochemischer Zelle sowie einen verbesserten Ladungstransport zwischen Lichtabsorber und Redox-System.

Die Aufgabe hinsichtlich der Vorrichtung wird durch eine photoelektrochemische Zelle mit den Merkmalen des Anspruchs 1 und einem System aus einer Vielzahl von photoelektrochemischen Zellen des Anspruchs 18 gelöst. Die Aufgabe hinsichtlich des Verfahrens wird durch ein Verfahren zur lichtgetriebenen Erzeugung von Wasserstoff und Sauerstoff aus Wasser oder einem auf wässriger Lösung basierenden Elektrolyten mit einer photoelektrochemischen Zelle gemäß den Merkmalen des Anspruchs 19 gelöst. Die Aufgabe führt auch auf ein Verfahren zur Herstellung einer photoelektrochemischen Zelle mit den Merkmalen des Anspruchs 20.

Eine Vorderseite des Schichtaufbaus bezeichnet nicht notwendigerweise eine vordere Oberfläche des Schichtaufbaus oder der photoelektrochemischen Zelle sondern gibt lediglich die für einen Lichteinfall vorgesehene Seite an. Eine Vorderseite des Schichtaufbaus kann eine Oberfläche sein oder auch eine von einer oder mehreren weiteren Schichten bedeckte Seite. Eine Rückseite des Schichtaufbaus bezeichnet nicht notwendigerweise eine hintere Oberfläche des Schichtaufbaus oder der photoelektrochemischen Zelle sondern gibt lediglich eine Seite an, die vorgesehen ist, vom Lichteinfall abgewandt zu sein. Eine Rückseite des Schichtaufbaus kann eine Oberfläche sein oder auch eine von einer oder mehreren weiteren Schichten bedeckte Seite.

Die Erfindung geht von der Überlegung aus, dass der Gesamtwirkungsgrad einer photoelektrochemischen Zelle durch physikalische Grenzen und darüber hinaus durch eine verbesserungswürdige Effizienzauslegung begrenzt wird. Dies betrifft insbesondere den Bereich der elektrochemischen Zelle und ihrer elektronischen Kopplungsmechanismen sowie den Ladungstransport an der Kopplungsgrenze des lichtabsorbierenden Systems in der Photovoltaikzelle und des Redox-Systems in der Elektrochemiezelle. Die Erfindung hat erkannt, dass es für eine großtechnische Realisierung vorteilhaft ist, diese und andere Kopplungsprobleme zu lösen.

Die Erfindung hat erkannt, dass dies innerhalb eines gesamtheitlichen, integrierten Ansatzes unter Bildung der gesamten photoelektrochemischen Zelle realisiert werden kann. Insbesondere werden nicht nur Einzelkomponenten, sondern der gesamte Aufbau einer photoelektrischen Schichtstruktur und einer elektrochemischen Schichtstruktur konsequent in einem integrierten Schichtaufbau, der über eine bloße Kopplung modularer Systeme hinausgeht, realisiert. Insbesondere wird im Rahmen des integrierten Schichtaufbaus eine effizienzoptimierte Schichtstruktur durch einzelne in ihren elektrischen und chemischen Eigenschaften aufeinander abgestimmten Schichten aufgebaut.

Dadurch können die Eigenschaften des Elektrolyten sowie der Ladungstransfer und damit der Energieübertrag an der Grenze zwischen dem lichtabsorbierenden System, insbesondere einer Solarzelle, und dem Redox-System, insbesondere einem elektrochemischen Reaktor, effizienzoptimiert werden. Dies macht die konsequente Umsetzung eines integrierten Schichtaufbaus im Bereich der Elektrochemiezelle und/oder Elektrochemiezelle möglich; mit entsprechenden Folgen für das Herstellungsverfahren einer photoelektrochemischen Zelle. Im Einzelnen bildet eine photoelektrische Schichtstruktur zur vom Wasser oder einem anderen wässrigen Elektrolyten unbeeinflussten Absorption von Licht eine Vorderseite des Schichtaufbaus aus und eine elektrochemische Schichtstruktur zur Aufnahme des Elektrolyten eine Rückseite des Schichtaufbaus aus, wobei die photoelektrische Schichtstruktur und die elektrochemische Schichtstruktur im Schichtaufbau über eine leitfähige und korrosionshemmende Koppelschicht miteinander elektrisch kontaktiert werden. Bevorzugt werden die photoelektrische Schichtstruktur und die elektrochemische Schichtstruktur als eine Sequenz von in Aufbaurichtung aufgebrachten Schichten einer einzigen Schichtabfolge in dem Schichtaufbau integriert. Bevorzugt werden die Schichten einzeln und nacheinander, insbesondere unterbrechungsfrei, aufgebracht. Bevorzugt ist die elektrochemische Schichtstruktur als eine elektrokatalytische Schichtstruktur ausgebildet und vereint damit elektrochemische und elektrokatalytische Funktionalitäten.

Das Konzept der Erfindung basiert vor allem auf einer funktionierenden Effizienzoptimierung der Ladungskopplung und des Ladungstransfers an den relevanten Systemgrenzen, nämlich an der Grenze des lichtabsorbierenden Systems zum Redox-System als auch in der Elektrochemiezelle. Außerdem kann auf der Grundlage es Konzepts der Erfindung eine Widerstandsoptimierung an den Systemgrenzen der photoelektrochemischen Zelle erfolgen. Wie von der Erfindung erkannt kann ein ganzheitlicher Design-Ansatz u. a. für die beteiligten elektrochemischen Potenziale und Bandstrukturen bzw. Fermi-Niveaus vorgenommen werden; d. h. nicht nur, aber vor allem an der Grenze einer Elektrochemiezelle und einer Photovoltaikzelle.

Das vorgeschlagene Konzept bildet die konstruktive Grundlage dafür, dass ein Elektronentransport --insbesondere an der Grenze zwischen dem lichtabsorbierenden System und dem Redox-System als auch im Redox-System-- in der photoelektrochemischen Zelle (PEC-Zelle) effizienzoptimiert ist. Zudem wird dies dadurch erreicht, dass unter Bildung eines gesamtintegrierten Schichtaufbaus der photoelektrochemischen Zellen eine Ionen-Austauschschicht der Elektrochemiezelle in Kontakt ist mit einer Elektrodenstruktur der Vorderelektrode und/oder Rückelektrode, die zur Umsetzung des Wassers oder einem anderen wässrigen Elektrolyten vorgesehen ist. Darüber wird in synergetischer Weise eine korrosionshemmende Kontaktierung von photoelektrischer Schichtstruktur und elektrochemischer Schichtstruktur auf der lichtabgewandten Seite der photoelektrischen Schichtstruktur vorgenommen. Dies verhindert die elektrochemische Zersetzung der Halbleiterschichtstruktur einer Solarzelle im Kontakt mit dem Elektrolyten. Außerdem erlaubt eine korrosionshemmende Koppelschicht eine grundsätzliche Designfreiheit hinsichtlich der Realisierung der photoelektrischen Schichtstruktur. Insbesondere kann mittels einer "face-to-face"-Elektrodenanordung, d. h. mittels einer Schichtanordnung der Elektroden im wesentlichen ohne freien Abstand, ein vergleichsweise kompakter Reaktionsraum für den elektrochemischen Reaktor zur Verfügung gestellt werden, der zum einen eine erhebliche Widerstandsoptimierung des Elektrolyt enthaltenden Bestandteils der PEC-Zelle darstellt und zum anderen eine effiziente elektrochemische Wasserdissoziation ermöglicht.

Darüber hinaus bietet das Konzept die Möglichkeit einer direkten Bestrahlung der photoelektrischen Schichtstruktur, ohne Absorptionseinflüsse durch Wasser oder anderen wässrigen Elektrolyten hinnehmen zu müssen. Insbesondere entfallen Verluste durch Absorption im Wasser oder einem anderen wässrigen Elektrolyten. Es entfallen auch Verluste durch Absorption an katalytischen Schichten und Rückstreuungsverluste an Blasen der Produktgase im Wasser oder einem wässrigen Elektrolyten. Wasser kann insofern jede Art eines pH-neutralen Elektrolyten umfassen; andere wässrige Elektrolyten --basisch oder sauer-- sind möglich.

Vorteilhafte Weiterbildungen der Erfindung sind den Unteransprüchen zu entnehmen und geben im Einzelnen vorteilhafte Möglichkeiten an, dass oben erläuterte Konzept im Rahmen der Aufgabenstellung sowie hinsichtlich weiterer Vorteile zu realisieren.

In einer besonders bevorzugten weiterbildenden Variante ist die photoelektrische Schichtstruktur und die elektrochemische Schichtstruktur als eine Sequenz von in Aufbaurichtung einzeln --insbesondere nacheinander und/oder unterbrechungsfrei-- aufgebrachten Schichten einer einzigen Schichtabfolge in dem Schichtaufbau integriert. Eine Aufbaurichtung kann beispielsweise die Richtung eines Wachstums, einer Deposition oder anderen Art von Anbringung einer Schicht bezeichnen; d. h. regelmäßig eine Richtung senkrecht zu einem Substrat oder dergleichen Basisschicht. Eine Aufbaurichtung kann z. B. den Aufbau einer photoelektrischen Schichtstruktur auf einem lichtdurchlässigen Substrat und anschließend den Aufbau einer elektrochemischen Schichtstruktur auf einer kontaktierenden Koppelschicht bezeichnen. Eine andere Aufbaurichtung kann z. B. den Aufbau einer elektrochemischen Schichtstruktur auf einer Rückelektrode und anschließend den Aufbau einer photoelektrischen Schichtstruktur auf einer kontaktierenden Koppelschicht bezeichnen.

Ein lichtdurchlässiger und leitfähiger Front-Schichtstapel kann eine optisch transparente leitende Schicht, wie ITO (Indiumzinnoxid), AZO (Aluminium dotiertes Zinkoxid), FTO (Fluor dotiertes Zinnoxid) oder ein anderes ZnO oder TCO (transparente leitfähige Oxidschicht) od. dgl. Schicht aufweisen. Insbesondere kann die photoelektrische Schichtstruktur aufgebracht werden auf Glas, Polymethylmetacrylaten (z. B. Plexiglas), Polycarbonaten, Polyethylentherephthalat, Polyacrylaten, Polyolefine oder einem transparenten polymerbasierten Substrat auf Basis eines leitenden Polymers (ICP) oder Gemischen daraus als transparentes Substrat.

In einer anderen weiterbildenden Variante kann die photoelektrische Schichtstruktur modular in Form einer Photovoltaikzelle und/oder die elektrochemische Schichtstruktur modular in Form einer Elektrochemiezelle zur Verfügung gestellt werden und mittels der leitfähigen und korrosionshemmenden Koppelschicht in dem Schichtaufbau assembliert sein. Eine photoelektrische Schichtstruktur kann bevorzugt als Dünnschicht-Solarzelle auf einem lichtdurchlässigen und/oder zumindest teilweise leitfähigen FrontSchichtstapel aufgebracht sein, wobei insbesondere eine Texturierung des Substrats und/oder FrontSchichtstapels vorgesehen ist. Bevorzugt sind für die Koppelschicht und die übrige Abstimmung der Module weitere Anforderungen zu stellen, von denen einige im Weiteren erläutert sind.

Die Elektrodenstruktur der Vorderelektrode und/oder der Rückelektrode kann in unterschiedlicher Weise angepasst sein, um eine Ionen-Austauschschicht ausreichend stabil zur Bildung eines Schichtstapels zu kontaktieren. Insbesondere kann eine Elektrodenstruktur geeignet ausgebildet sein, um Reaktionsräume für eine wasserdissoziierende Redox-Reaktion sowie ausreichende Durchlässigkeit für Reaktionsgase zur Verfügung zu stellen. Der Kontakt der Ionen-Austauschschicht kann insbesondere mit einer zur Umsetzung von Wasser oder einem anderen wässrigen Elektrolyten vorgesehenen Funktionsschicht erfolgen. Der Kontakt kann ein sich wenigstens bereichsweise über den Querschnitt der Funktionsschicht erstreckender direkter Kontakt sein. Insbesondere kann der Kontakt ein sich teilweise oder praktisch vollflächig über den Querschnitt erstreckender direkter Kontakt sein. Besonders vorteilhaft wird der Kontakt durch eine regelmäßige und/oder unregelmäßig Anordnung von Kontaktstellen gebildet, die sich teilweise oder praktisch vollflächig über den Querschnitt der Funktionsschicht verteilen. Die Austauschschicht ist bevorzugt eine Membran oder eine Fritte, kann aber auch ein Vlies oder sonstiger Ionen-Austausch-Filter sein, der gegenüber den Produktgasen Wasserstoff und Sauerstoff undurchlässig ist.

Vorteilhaft ist eine zur Umsetzung des Wassers oder wässrigen Elektrolyten vorgesehene Funktionsschicht gemäß der Erfindung, zur Umsetzung des Wassers oder wässrigen Elektrolyten, als separate Schicht auf einer massiven Vorderelektrode und/oder Rückelektrode aufgebracht. Insbesondere ist eine Funktionsschicht elektrisch leitfähig und durchlässig für Produktgase. Die erste und/oder zweite Funktionsschicht weist bevorzugt eine für die Vorderelektrode und/oder Rückelektrode oberflächenvergrößernde Funktionalität auf. Es lässt sich vorteilhaft das Redox-System der Elektrochemiezelle an sich optimieren, durch die geeignete Ausbildung der Funktionsschichten, wie zum Beispiel durch die Wahl einer geeigneten Porosität und der damit verbundenen Erhöhung der katalytischen Wirkung.

Insbesondere weist die erste und/oder zweite Funktionsschicht Poren, Öffnungen oder dgl. Aufnahmebereiche für den Elektrolyten und/oder eine Durchlässigkeit für die Prozessgase (Wasserstoff und Sauerstoff) auf. Unter einem massiven Bereich der Elektrodenstruktur ist insofern ein Bereich zu verstehen, der undurchlässig dicht bzw. nicht zugänglich für Reaktionsgase ist. Damit kann ein Reaktionsraum vorteilhaft gestaltet werden.

Besonders vorteilhaft stimmt der Querschnitt einer Funktionsschicht mit einem Querschnitt der Vorderelektrode und/oder der Rückelektrode überein. Ein vollflächiger Kontakt, der sich vollflächig über den Querschnitt der Funktionsschicht erstreckt, belässt bevorzugt dennoch geeignete Aufnahmebereiche einer Funktionsschicht, die ausreichende Reaktionsräume für die Wasserdissoziation zur Verfügung stellen. Insbesondere ist als Querschnitt der Funktionsschicht vorzugsweise der Querschnitt der Vorderelektrode und/oder der Rückelektrode vorgesehen. Dies ermöglicht eine sowohl für das Herstellungsverfahren als auch für die konstruktive Basis besonders bevorzugte "face-to-face" Elektrodenanordnung in der photoelektrochemischen Zelle. Letztendlich erlaubt dies einen minimalen Elektrodenabstand, der praktisch auf die Dicke der Ionen-Austauschschicht reduziert werden kann; damit kann eine erhebliche Widerstandsoptimierung zum Elektrolyten in einer photoelektrochemischen Zellen dargestellt werden.

Als Elektrolyt kommen sowohl flüssige basische als auch feste basische Systeme in Frage, wobei der schädliche Einfluss auf das Photovoltaikzellsystem und die sonstigen festen Komponenten der photo-elektrochemischen Zelle zu berücksichtigen sind. In einer besonders bevorzugten Weiterbildung der Erfindung wird die Ionen-Austauschschicht derart gewählt, dass sie --z. B. bei Verwendung einer basischen Polymerelektrolytmembran (PEM) oder Komposit-Membran, bestehend aus einer Polymermembran mit anorganischen bzw. keramischen Füllmaterialien-- einen festen Elektrolyten ausbildet. Unter einer Komposit-Membran ist in diesem Zusammenhang eine Polymermembran zu verstehen, die mit anorganischen bzw. keramischen Füllmaterialien versehen ist. Insbesondere kann eine Polymerelektrolytmembran (PEM) mit einer erhöhten Ionenbeweglichkeit und/oder Gasdichtigkeit gegenüber Wasserstoff und Sauerstoff verwendet werden. Bevorzugt ist, dass der Elektrolyt eine wässrige Lösung, vorzugsweise mit einem pH-Wert zwischen 5 und 8, umfasst, insbesondere der Elektrolyt eine 0.01 M bis 1 M Lösung umfasst. Insbesondere kann dann die Verwendung eines wässrigen deutlich basischen Elektrolyten weitegehend entbehrlich sein.

Gemäß der Erfindung hat sich ein Elektrolyt mittels einer basischen wässrigen Lösung als besonders vorteilhaft erwiesen; nämlich ein Elektrolyt, der mit einem pH-Wert zwischen 7.1 und 14, gebildet ist. Insbesondere kann der Elektrolyt eine Alkali- oder Erdalkalimetallhydroxidlauge umfassen, vorzugsweise Natronlauge, Kalilauge oder Kalkwasser oder einer basischen Polymerelektrolytmembran (PEM) gebildet sein.

Das Konzept bietet auch die Möglichkeit, im Rahmen von weiteren Weiterbildungen, bislang bekannte großtechnische Lösungen, insbesondere im Bereich einer photoelektrischen Schichtstruktur sinnvoll und ohne deutliche Wirkungsgradeinbußen in einem Gesamtkonzept einer photoelektrochemischen Zelle zu integrieren; nämlich indem die photoelektrische Schichtstruktur und die elektrochemische Schichtstruktur im Schichtaufbau über eine leitfähige und korrosionshemmende Koppelschicht miteinander elektrisch kontaktiert sind. Beispielsweise bietet das Konzept, die Möglichkeit, an sich vorteilhafte Ansätze einer z. B. hinsichtlich Photospannung optimierten a-Si/µc-Si-Dünnschicht-Solarzelle zur Darstellung einer Tandem- oder Tripel-Solarzelle zu nutzen und in einem gesamtheitlich optimierten Aufbau einer photoelektrochemischen Zelle zu integrieren, ohne dass gravierende Wirkungsgradeinbußen hingenommen werden müssten; nämlich indem einzelne in ihren elektrischen und chemischen Eigenschaften aufeinander abgestimmten Schichten zum integrierten Schichtaufbau aufgebaut werden.

Der Ladungstransfer (Elektronen oder Löcher) zwischen der photoelektrischen Schichtstruktur (beispielsweise einer Silizium-basierten Dual-Junction Photodiodenstruktur) und der elektrochemischen Schichtstruktur sollte durch geeignete Koppelschicht(en), z. B. wirksam als Pufferschichten unter Minimierung der Ladungsträgerrekombination und des Verlustes der erzeugten Photospannung, optimiert werden. Die elektronische Struktur und das Kontaktverhalten der Schichten können in ihrer Kopplung zueinander angepasst werden, insbesondere Schicht für Schicht. Anzustreben ist eine Koppelschicht, insbesondere eine Koppel-Schichtabfolge, als Grenzschicht(en) mit Kopplungsniveaus am Valenzband des photoelektrischen Energiewandlermaterials für Lochreaktionen und am Leitungsband für Elektronenreaktionen.

Darüber hinaus stellt das gezielte Engineering der Koppelschicht, insbesondere Pufferschicht, auf den photoelektrischen Schichtstrukturen eine Herausforderung für eine effiziente Kopplung mit der elektrochemisch aktiven Schichtstruktur dar. Eine insbesondere für eine effiziente Kopplung mit der elektrochemisch aktiven Schichtstruktur vorteilhafte Koppelschicht als Pufferschicht sollte besonders bevorzugt zudem synergetisch gleichzeitig mehrere Anforderungen erfüllen, wie die chemische Stabilisierung des Substrats und/oder den Transfer von Ladungsträgern aus der Photodiode zum Katalysator, insbesondere ohne Rekombination von Ladungsträgern und/oder Verlust des elektrochemischen Potentials und/oder die Anbindung von Mehrelektronentransfer-Katalysatoren. Hierzu können gezielt Schichtstapel mit angepassten Kontakteigenschaften kontrolliert und ohne Erzeugung von Grenzflächendefekten als Schichtabfolge von Koppelschichten aufgebracht und in den elektronischen Eigenschaften hinsichtlich des Ladungstransfers optimiert werden.

Generell können die verwendeten Festkörpermaterialien wie Halbleiter, TCO und Metall sowohl im Kontakt zueinander als auch im Kontakt zum Elektrolyten in Bezug auf die Korrosionsfestigkeit und Energetik, d. h. Photospannung und Bandanpassung, für die Wasserstofferzeugung optimiert werden. Es können Halbleiterschichtsysteme für eine Tandem oder Tripelzellenstruktur unter Verwendung von III-V-Verbindungshalbleitern wie z. B. GaAs/AlGaAs, InP, GaP etc. frei von äußeren Bedingungen und internen Gegebenheiten wie beispielsweise dem Elektrolyten oder dergleichen angepasst werden. Die Erfindung löst damit das ungelöste Stabilitätsproblem dieser Klasse von Halbleiterstrukturen im Hinblick auf den Elektrolyten unter Berücksichtigung ausreichender Freiheitsgrade bei den Vorgaben im Betrieb einer photoelektrochemischen Zelle. So können auch Solarzellenkonzepte mit Wirkungsgraden zwischen 9 und 10 % bis hin zu 25 % effektiv in das vorliegende Konzept eingebracht werden. Insbesondere ist es möglich, vorzugsweise in Kombination mit einer porösen Funktionsschicht und/oder Elektrode, dass sich im Bereich wenigstens der ionenleitenden Austausch-Schicht --wie einer Membran, Fritte oder Vlies-- zur Trennung der beiden Produktgasräume zwischen den massiven Teilen der Elektroden, ein ausreichender Reaktionsraum für Wasser oder wässrigen Elektrolyten zur Verfügung stellen lässt. Außerdem wird die Durchmischung der Produktgase --und somit deren Rückreaktion zu Wasser-- verhindert.

Insbesondere ermöglicht der Aufbau einer "face-to-face" Elektrodenanordnung einen minimalen Elektrodenabstand im Bereich der Membrandicke. Insbesondere umfasst der Reaktionsraum nicht nur die Membran sondern auch gegebenenfalls oberflächenvergrößerte Bereiche der Funktionsschicht oder der Elektrode, welche vom Elektrolyten durchsetzt werden können. Bevorzugt ist, dass sich eine Funktionsschicht wenigstens auf der zur Wasserstoffproduktion vorgesehenen Elektrode, insbesondere der Kathode, befindet. Bevorzugt ist eine erste Funktionsschicht auf der Vorderelektrode, insbesondere einer Kathode, und/oder eine zweite Funktionsschicht auf der Rückelektrode, insbesondere einer Anode, angeordnet und die Ionen-Austauschschicht ist in Kontakt mit der ersten Funktionsschicht auf der Vorderelektrode und/oder der zweiten Funktionsschicht auf der Rückelektrode. Die Funktionsschichten, d. h. die erste und die zweite Funktionsschicht, können unterschiedlich ausgestaltet sein hinsichtlich Material, Funktion und räumlicher Ausdehnung - die einzelne Ausbildung kann abgestimmt sein auf die Funktion der Vorderelektrode und/oder der Rückelektrode. Auch kann die Wahl der Materialien und die sonstigen Auslegungsparameter auf eine großtechnische Bildung des integrierten Schichtaufbaus unter direkter Kontaktierung der Ionen-Austauschschicht abgestimmt sein.

Gemäß der Erfindung weist die erste und/oder zweite Funktionsschicht eine die Umsetzung des Elektrolyten an der Vorderelektrode und/oder Rückelektrode katalytische Funktionalität auf, genauer gesagt trägt diese einen Katalysator, insbesondere mit großer Oberfläche. Insbesondere weist der Katalysator eine oder mehrere Aktivkomponenten und ein Trägermaterial auf.

Es werden edelmetallarme Katalysatorsysteme, vorzugsweise mit einer Aktivkomponente umfassend Übergangsmetallverbindungen oder Mischungen aus Übergangsmetallverbindungen zur Bildung des Katalysators, verwendet, insbesondere unter Verwendung von Elementverbindungen der IV. bis XII. Nebengruppe; beispielsweise in Form von strukturierten oder porösen Schichten oder nanopartikulären Systemen. Gemäß der Erfindung basiert die Aktivkomponente auf einem oder mehreren, insbesondere Verbindungen, der Elemente ausgewählt aus der Gruppe Ti, V, Cr, Mo, W, Mn, Fe, Ru, Co, Ni, Cu,Zn. Eine Maßnahme mit einer vorteilhaften Katalysatorwahl beschleunigen die Wasserdissoziation.

Insbesondere kann eine zur Umsetzung des Wassers oder wässrigen Elektrolyten vorgesehene Funktionsschicht elektrisch leitfähig und durchlässig für Produktgase sein. Beispielsweise hat sich eine zur Umsetzung des Elektrolyten vorgesehene Funktionsschicht auf Basis von Kohlenstoff oder Graphit als besonders vorteilhaft erwiesen. Besonders bevorzugt ist ein von der Elektrodenstruktur der Vorder- und/oder Rückelektrode getragener Katalysator als eine partikuläre und/oder immobilisierte molekulare Form und/oder massive und/oder poröse Schichten gebildet.

Im Rahmen einer besonders bevorzugten Weiterbildung trägt eine erste Funktionsschicht einen wasseroxidierenden Katalysator in einer oberflächenvergrößerten Oberfläche der kathodischen Vorderelektrode und eine zweite Funktionsschicht einen wasserreduzierenden Katalysator in einer oberflächenvergrößerten Oberfläche der anodischen Rückelektrode, wobei die Ionen-Austauschschicht in Kontakt mit der ersten Funktionsschicht und der zweiten Funktionsschicht ist. Im Rahmen einer besonders bevorzugten alternativen Weiterbildung der Erfindung hat es sich als vorteilhaft erwiesen, dass eine erste Funktionsschicht einen wasseroxidierenden Katalysator in einer Oberflächen vergrößerten Oberfläche der kathodischen Rückelektrode und eine zweite Funktionsschicht einen wasserreduzierenden Katalysator in einer Oberflächen vergrößerten Oberfläche der anodischen Vorderelektrode trägt, wobei die Ionen-Austauschschicht in Kontakt mit der ersten Funktionsschicht und der zweiten Funktionsschicht ist. Die Wahl der Alternativen ist mit der Wahl der Polarität der photoelektrischen Schichtstruktur bzw. Photovoltaikzelle verbunden. Im ersteren Fall kontaktiert die Vorderelektrode eine n-dotierte Schicht der photoelektrischen Schichtstruktur, im letzteren Fall kontaktiert die Vorderelektrode eine p-dotierte Schicht der photoelektrischen Schichtstruktur.

Insbesondere ist die leitfähige und korrosionshemmende Koppelschicht direkt zwischen einer Strukturschicht einer photoelektrischen Schichtstruktur und einer Vorderelektrode eines elektrochemischen Reaktors aufgebracht. Die Strukturschicht ist insbesondere ein n- oder p-dotierter Halbleiterstapel einer pin-Struktur. Im Falle einer Tandem- oder Tripel-Solarzelle bildet die photoelektrische Schichtstruktur vorzugsweise die Bottom-Solarzelle.

Vorzugsweise ist die leitfähige und korrosionshemmende Koppelschicht in Form einer Passivierungsschicht ausgebildet und/oder als metallische Schicht aufgebracht. Es hat sich als besonders bevorzugt erwiesen, dass die leitfähige und korrosionshemmende Koppelschicht metallisch ist. Als besonders geeignet im Hinblick auf eine effektive Elektrodenkopplung zwischen lichtabsorbierenden und Redox-System hat sich eine korrosionshemmende Koppelschicht basierend auf Graphit, Silber oder Edelstahl oder anderen elektrolyt-resistenten Metallen erwiesen. Insbesondere kann eine Koppelschicht auf Basis von leitfähigen Metalloxiden bzw. Mischmetalloxiden oder Metallnitriden und/oder deren Legierungen ausgeführt sein.

Eine korrosionshemmende Schicht hat sich als besonders wirksam bei einer Tandem-Solarzelle erwiesen. Insbesondere einer Tandemsolarzelle mit einer pin-Struktur auf Basis von Silizium, nämlich insbesondere amorphen Silizium (a-Si) und mikrokristallinem Silizium (µc-Si) in Form einer Dünnschicht-Solarzelle erwiesen. Die Kombination einer Tandem-Solarzelle auf Basis von a-Si und µc-Si ermöglicht zum einen --auch in Abgrenzung zu Tripel-Solarzellen--vergleichsweise dünnen und großtechnisch leicht herzustellenden Aufbau, der durch die korrosionshemmende Schicht geschützt, einen guten Elektronentransport in die Elektrochemische Zelle erlaubt.

Insbesondere lässt sich auch eine Photovoltaikseite der photoelektrochemischen Zelle optimieren, beispielsweise durch die Wahl breitbandiger und effizienter Lichtabsorber, wie etwa durch die Auswahl geeigneter Halbleitermaterialien oder Single-Wide-Band-Gap oder Multi-Junction-Zellen. Voraussetzung ist eine für die Wasserspaltung erforderliche Photospannung von größer oder gleich 1.4 V zwischen der Vorderelektrode und der Rückelektrode der Elektrochemiezelle zur Verfügung zu stellen, ohne zu große Thermosilierungsverluste hinnehmen zu müssen.

Es kann mit Hilfe von Tandemzellen eine Photospannung deutlich größer als 1.23 V erzeugt werden, die für die Wasserspaltung mindestens erforderlich ist. Die Erweiterung des Tandemzellenkonzepts auf ein Tripelzellenkonzept ermöglicht darüber hinaus die Erzeugung höherer Photospannungen und damit die Kompensation von Überspannung bei der Herstellung von Wasserstoff unter höheren Stromdichten, die vorzugsweise zwischen 20 mA/cm² und 100mA/cm² liegen; dies ist eine vorteilhafte Voraussetzung für die großtechnische Produktion. Diesen Vorteil bietet grundsätzlich auch eine Photovoltaikzelle, die als Single-Junction-Solarzelle auf Basis eines Halbleitermaterials mit einer Bandlücke größer als 1.6 V ausgebildet ist, beispielsweise Basis von Gruppe III-V, II-VI oder IV-IV Halbleiterverbindungen, vorzugsweise auf Basis von GaP, ZnTe, CdSe, CdS oder SiC. Solche oder andere "Wide Bandgap"-Materialien haben grundsätzlich auch den Vorteil einer Erzeugung höherer Photospannungen unter Kompensation von Überspannungen. Das Prinzip einer Superstrate-Solarzelle (Solarzelle, die auf einem durchsichtigen Träger als Substrat aufgebracht wird) ist schon länger bekannt und wird vor allem bei Dünnschicht-Solarzellen auf Glas als Trägermaterial zur Gewinnung von elektrischer Energie eingesetzt. Dieser Zelltyp wurde bisher jedoch noch nicht als Grundlage für eine elektrochemische Zelle für die Wasserspaltung mittels Licht eingesetzt. Die Verknüpfung beider Technologien hat sich im Rahmen des vorliegenden Konzepts als erfolgreich unter Effizienzoptimierungsgesichtspunkten erwiesen.

Im Folgenden werden elektrochemische Zellen anhand der Figuren beschrieben. Es zeigen:

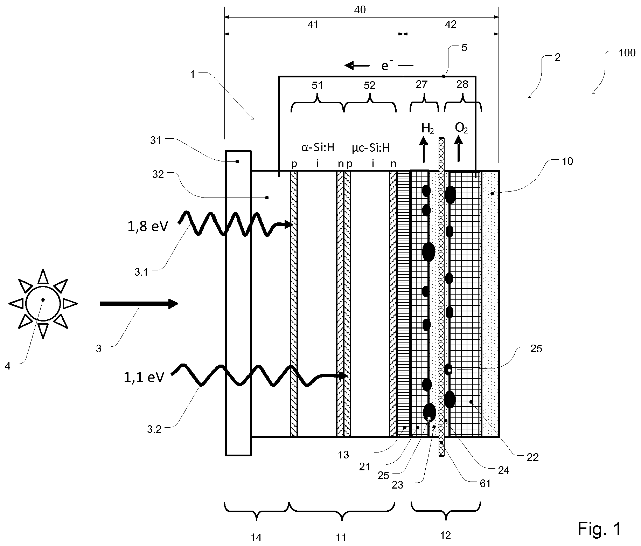

Fig. 1: eine Ausführungsform einer photoelektrochemischen Zelle zur lichtgetriebenen Erzeugung von Wasserstoff und Sauerstoff aus Wasser oder einem auf wässriger Lösung basierenden Elektrolyten mit einer a-Si und µc-Si basierten Tandem-Photovoltaikzelle und einer Elektrochemiezelle, die beide in einen gesamtheitlich optimierten Schichtaufbau der PEC integriert sind, d. h. mittels einer photoelektrischen Schichtstruktur und einer elektrochemischen Schichtstruktur im Rahmen einer Sequenz von in Aufbaurichtung einzeln in ihren elektrischen Eigenschaften aufeinander abgestimmten aufgebrachten Schichten integriert sind;

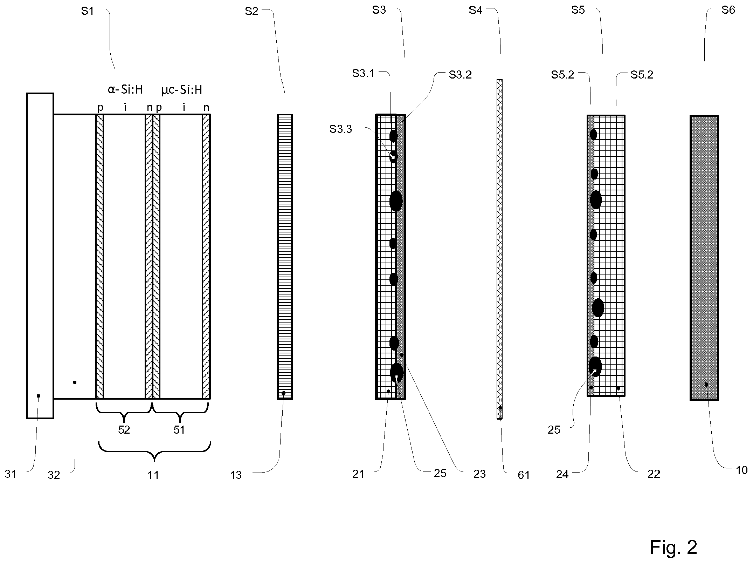

Fig. 2: eine Explosionsdarstellung der in Fig. 1 gezeigten Zelle zur Erläuterung eines Herstellungsverfahrens unter Realisierung des insgesamt integrierten Aufbaus.

Fig. 1 zeigt eine photoelektrochemische Zelle (PEC) 100 anhand der grundsätzlich deren Wirkungsweise zur lichtgetriebenen Erzeugung von Wasserstoff H₂ und Sauerstoff O₂ aus Wasser oder einem anderen auf wässriger Lösung basierenden Elektrolyten 10 --hier eine nicht erfindungsgemäße 0.1 M H₂SO₄ - wässrige Lösung im sauren Bereich mit einem pH-Wert von ungefähr 1--, der in einem Vorratsraum oder dergleichen Einrichtung vorgehalten wird und zur weiteren Umsetzung zur Verfügung steht. Die photoelektrochemische Zelle 100 weist eine photoelektrische Schichtstruktur 1 und eine elektrochemische Schichtstruktur 2 auf. Vorliegend umfasst die photoelektrische Schichtstruktur 1 einen integrierten Schichtaufbau einer Solarzelle 11 auf einer Vorderseite 41 eines weitestgehend monolithischen und insgesamt integrierten Schichtaufbaus 40 auf. Die elektrochemische Schichtstruktur 2 umfasst einen weiteren integrierten Schichtaufbau eines elektrochemischen Reaktors 12 auf einer Rückseite 42 des weitestgehend monolithischen und insgesamt integrierten Schichtaufbaus 40; nämlich insbesondere eine Anordnung einer elektrodischen Struktur im Schichtaufbau 40, die auch zur Aufnahme des Elektrolyten 10 geeignet ist. Sowohl die Solarzelle 11 als auch der elektrochemische Reaktor 12 sind konsequent in einem insgesamt integrierten Schichtaufbau 40 realisiert. Die Integration einer Solarzelle 11 und eines elektrochemischen Reaktors 12 zur photoelektrochemischen Zelle PEC 100 erfolgt über eine elektrische Kontaktierung in einer leitfähigen, korrosionshemmenden Koppelschicht 13. Der insgesamt effizienzoptimierte integrierte Schichtaufbau 40 wird mittels einer photoelektrische Schichtstruktur 1, der Koppelschicht 13 und der elektrochemischen Schichtstruktur 2 Schicht für Schicht gebildet.

Licht 3 einer Lichtquelle 4, beispielsweise Sonnenlicht oder künstliches Licht, fällt durch ein Eintrittsfenster --hier ein Substrat 31 aus Glas für die Solarzelle 11-- direkt auf die aktiven pin-Strukturen der Solarzelle 11 und erzeugt dort Elektronen-Loch-Paare, die im elektrischen Gradientenfeld der pin-Strukturen im Inneren der Solarzelle 11 getrennt werden. Vorliegend werden hochenergetische Lichtanteile 3.1, insbesondere das sichtbare und ultraviolette Spektrum (VIS, UV), in einer vorderen Struktur einer Top-Solarzelle 51 und niederenergetische, insbesondere infrarote (IR), Lichtanteile 3.2 in einer hinteren Struktur einer Bottom-Solarzelle 52 absorbiert. Die Erzeugung von Elektrodenlochpaaren erfolgt möglichst breitbandig sowohl für einen sichtbaren als auch einen infraroten Anteil des Lichts. Die Top- und Bottom-Solarzelle 51, 52 ist jeweils als eine pin-Halbleiterstruktur gebildet, nämlich zur Erzeugung einer Photospannung größer als 1.5 V. Dazu ist die vordere Top-Solarzelle 51 auf Basis von amorphem a-Silizium als a-Si:H pin-Struktur gebildet und die hintere Bottom-Solarzelle 52 auf Basis von mikrokristallinem Silizium, nämlich als µc-Si:H pin-Struktur, gebildet.

Zur wirtschaftlichen Erzeugung einer ausreichenden Photospannung zur elektrochemischen Wasserspaltung eignen sich insbesondere Silizium-Dünnschichtsolarzellen, die auf der Basis der Tandemsolarzellen-Technologie für den Einsatz im Gesamtmodul optimiert werden. Hierbei sollte insbesondere eine Anpassung der sogenannten Leerlaufspannung *V*_{oc} an die Bedürfnisse der Wasserstofferzeugung vorgenommen werden. Um anodische und kathodische Überspannungen bei der Wasserspaltung zu kompensieren, sollte *V*_{oc} vorteilhaft bei etwa 1.6-1.8 V liegen. Gleichzeitig sollte die Spannung im sogenannten Arbeitspunkt maximaler Leistung *V*_{MPP} nicht zu weit unter *V*_{oc} liegen, da eine ausreichende Effizienz der elektrochemischen Reaktion ansonsten nicht gegeben ist. Dazu bedarf es der Realisierung von Stapelsolarzellen mit optimaler Stromanpassung zwischen den Teilzellen bei optimierter *V*_{oc} und hoher Zelleffizienz. Die Solarzelle 11 ist als Tandemzelle aus Top-Solarzelle 51 und Bottom-Solarzelle 52 auf einem Frontseitenkontakt 32 aus einem transparenten leitenden Material --hier eine TCO-Schicht-- aufgebracht, der wiederum auf dem Substrat 31 aus Glas aufgebracht ist. Das Substrat 31 kann in einer Alternative auch wieder entfernbar sein. Eine Koppelschicht und/oder ein Frontseitenkontakt 32 kann ganz allgemein in Form eines lichtdurchlässigen und/oder leitfähigen Schichtaufbaus zum Verbleib auf einer Vorderseite der Dünnschicht-Solarzelle allein oder mit dem Substrat als Teil des Eingangsfensters auf dem Front-schichtstapel 14 gebildet sein.

Die leitfähige korrosionshemmende Schicht 13 ist rückwärtig der Bottom-Solarzelle 52 aufgebracht; nämlich dort auf der n bezeichneten n-dotierten Strukturschicht 52n. Insgesamt dient der Schichtstapel der Schichten mit den Bezugszeichen 51, 52, 13 zur Erzeugung von Ladungsträgern mittels dem durch das aus Schichten des Substrats und Frontschichtstapels 31, 32 gebildeten Fenster einfallenden Lichts 3; die Ladungsträger werden an die Elektrolyt-Festkörper-Grenzfläche an einer ersten Vorderelektrode 21 --hier eine Kathode-- gegenüberliegend einer Rückelektrode 22 --hier eine Anode-- abgeleitet. Die Ladungsträger bauen so ein Potenzial zwischen Kathode und Anode auf und treiben damit eine Wasserstofferzeugungsreaktion an, die engl. auch hydrogen evolution reaction oder abgekürzt HER genannt wird. Diese dient zur Erzeugung und Abführung der mit Pfeilen symbolisierten Teile von Wasserstoff H₂ und Sauerstoff O₂ im Reaktionsraum. Der Reaktionsraum ist hier durch Funktionsschichten 23, 24 in Kontakt mit der Ionen-Austauschschicht 61 gebildet. Der Ladungsausgleich erfolgt über eine extern prozessierte Leiterbahn 5, die für einen Elektrodenrückfluss über den Frontseitenkontakt 32 sorgt.

Die zur Bildung der Elektrochemiezelle 2 erforderliche Ionen-Austauschschicht 61 ist zwischen der Vorderelektrode 21 und der Rückelektrode 22 angeordnet. Zur Beschleunigung der elektrochemischen Reaktion an der Vorder- und Rückelektrode 21, 22 sind diese jeweils mit einer Funktionsschicht, nämlich einer ersten Funktionsschicht 23 für die Vorderelektrode und einer zweiten Funktionsschicht 24 für die Rückelektrode belegt. Diese stellen beide eine oberflächenvergrößerte Oberfläche für die Elektroden 21, 22 zur Verfügung. Die Funktionsschichten 23, 24, bzw. deren Porenöffnungen oder dergleichen Aufnahmebereiche, sind dem Elektrolyten 10 zugänglich, sodass die Wasserdissoziation letztlich in den oberflächenvergrößernden Aufnahmebereichen der Funktionsschichten 23, 24 stattfindet bzw. an der Grenze zu einem massiven Bereich des Aufbaus der Vorder- und Rückelektroden 21, 22, der weder dem Elektrolyten 10 noch den Reaktionsgasen H₂, O₂ zugänglich ist. Die erste Funktionsschicht 23 weist eine innere oberflächenvergrößerte Oberfläche auf, die mit einem Katalysator 25 versetzt ist, der zur Beschleunigung der Wasserdissoziation und damit der Erzeugung von Wasserstoff H₂ dient. Der Katalysator 25 weist insofern eine oder mehrere Aktivkomponenten auf, die in einem Trägermaterial der Funktionsschicht 23 untergebracht sind. Eine Aktivkomponente eines hier von der Elektrodenstruktur der Vorderelektrode 21 getragenen Katalysators 25 basiert auf Übergangsmetallverbindungen oder Mischungen aus Übergangs-metallverbindungen, insbesondere unter Verwendung von Elementverbindungen der IV. bis XII. Nebengruppe; gemäß der Erfindung basieren die Aktivkomponente auf Elementen ausgewählt aus der Gruppe umfassend: Ti, V, Cr, Mo, W, Mn, Fe, Ru, Co, Ni, Cu, Zn. Ein Trägermaterial eines hier von der Elektrodenstruktur der Vorderelektrode 21 --ggfs. auch der Rückelektrode 22-- getragenen Katalysators 25 kann auf Materialien basierend auf Elementen oder Elementverbindungen der II. bis IV. Hauptgruppe und/oder der Nebengruppe IVb gebildet sein. Insbesondere haben sich Materialien auf Basis von Kohlenstoffmaterialien und/oder basierend auf Oxiden oder Mischoxiden von einem oder mehreren Elementen ausgewählt aus der Gruppe umfassend: Al, Si, Ti, Zr bewährt. Insbesondere kann eine zur Umsetzung des Wassers im Elektrolyten 10 vorgesehene Funktionsschicht 23, 24 auf Kohlenstoff oder Graphit basieren.

Da in der Regel die Halbleiterschichten von Solarzellen im direkten Kontakt mit wässriger Lösung elektrochemisch anfällig bzw. nicht stabil sind, ist vorliegend die Solarzelle 11 auf dem der Elektrolyten 10 zugewandten Seite durch eine korrosionshemmende Koppelschicht 13 geschützt, die als leitfähige Passivierungsschicht gebildet ist. Vergleichsweise gute korrosionshemmende oder korrosionsschützende Passivierungsschichten sind meistens lichtundurchlässig, was im vorliegenden Fall eines Aufbaus der photo-elektrochemischen Zelle jedoch unerheblich ist. Vielmehr kann die leitfähige Passivierungsschicht zusätzlich lichtreflektierende Eigenschaften aufweisen, um die Lichtabsorption in der Solarzellenstruktur der Bottom- und Top-Solarzelle 51, 52 zu erhöhen. Vorliegend kann nämlich die mit dem Wasser oder einem anderen wässrigen oder festen Elektrolyten 10 in Kontakt stehende Seite der Photovoltaikzelle 1 nicht beleuchtet werden, in der Elektrochemiezelle PEC findet insofern eine Dunkelreaktion statt. Im vorliegenden Fall ist die leitfähige Passivierungsschicht als echte Korrosionsschutzschicht mittels einer dünnen geschlossenen Silberschicht realisiert, die nur wenige 100 nm dick sein muss. Diese zusätzliche Passivierungsschicht 13 verhindert, dass sich die Halbleiterschichten der Solarzelle 11 im wässrigen Elektrolyt 10 auflösen, ohne den Ladungstransport der in der Solarzelle 11 durch Lichteinfall erzeugten Ladungsträger zu behindern. Die Passivierungsschicht ist im vorliegenden Fall --nämlich aus Silber-- auch so gewählt, dass auf diese leicht die Vorderelektrode 21 --hier nämlich die Kathode zur Wasserreduktion von Wasserstoff-- aufgebracht werden kann. Die Vorderelektrode 21 ist insgesamt aus porösem leitfähigem Material gebildet und weist eine erste Funktionsschicht 23 aus ebenfalls porösem Material auf, das katalytisches Material des Katalysators 25 in Form von nicht erfindungsgemäßen Platin-Nanopartikeln trägt. Die Rückelektrode 22 kann in gleicher Weise mit einem Katalysator 25 ausgerüstet sein.

Zwischen der Vorderelektrode 21 und der --im vorliegenden Fall besonders vorteilhaft-- ebenfalls porösen Rückelektrode 22 --in diesem Beispiel die Anode zur Wasseroxidation zu Sauerstoff O₂-- befindet sich die vorgenannte Ionen-Austauschschicht 61 in Form einer ionenleitenden Membran. Diese Ionen-Austauschschicht 61 kann als Membran aber auch als Fritte oder sonstiges ionentauschendes aber Gasdiffusion hemmendes Filter-Material gebildet sein und trennt den vorderen Elektrodenraum 27 vom hinteren Elektrodenraum 28 zur Wasser- bzw. Sauerstoffproduktion. Die Elektrodenräume 27, 28 umfassen vorliegend sämtliche vom Wasser bzw. wässrigen oder festen (z. B. basische PEM) Elektrolyten 10 durchsetzbare Bereiche, d. h. im Wesentlichen die porösen mit Öffnungen versehenen Bereiche der Funktionsschicht 23, 24 bzw. die löchrigen oder sonstigen porösen Bereiche der Vorder- und Rück-Elektrode 21, 22. Mindestens einer der Elektrodenräume 27, 28 füllt sich mit Wasser oder einem anderen wässrigen Elektrolyten 10 und stellt damit Reaktionsräume für die Wasserdissoziation zur Verfügung. Der wässrige Elektrolyt 10 ist hier entgegen der Lehre der Erfindung als eine wässrige 0.1 M H₂SO₄ Lösung gebildet, deren pH-Wert bei etwa pH=1 liegt. Die Wahl eines sauren Milieus ist vorliegend möglich, da die leitfähige Passivierungsschicht 13 die photoelektrische Schichtstruktur 1 ausreichend schützt. Im Ergebnis verhindert die Ionen-Austauschschicht 61 die Durchmischung der Produktgase H₂ und O₂ und deren Rückreaktion zu Wasser.

Im vorliegenden Fall wird unter Bildung eines integrierten Schichtaufbaus 40 der photoelektrochemischen Zelle 100 eine face-to-face Anordnung der Vorderelektrode 21 mit Funktionsschicht 23 und der Rückelektrode 22 mit Funktionsschicht 24 in direkten Kontakt mit der Ionen-Austauschschicht 61 realisiert. Dabei ist der Elektrodenabstand zwischen Vorderelektrode 21 mit Funktionsschicht 23 und Rückelektrode 22 mit Funktionsschicht 24 praktisch auf die Dicke der Ionen-Austauschschicht 61 reduziert. Dies ermöglicht eine deutliche Widerstandsoptimierung des Elektrolyten 10 in der photoelektrochemischen Zelle 100. Andererseits ist vorliegend mittels der Porosität ein Aufnahmebereich für Wasser oder den wässrigen Elektrolyten 10 zur Verfügung gestellt, der zur Ausbildung von ausreichend großen Reaktionsräumen in den Elektrodenräumen 27, 28 dient.

Fig. 2 zeigt anhand der in Fig. 1 beispielhaft dargestellten besonders bevorzugten Ausführungsform einer insgesamt integriert aufgebauten photoelektrochemischen Zelle PEC 100 ein Herstellungsverfahren derselben. Wie zuvor erläutert kann in einer Variante eine Solarzelle 11 in einem ersten Verfahrensschritt S1 aus üblicher Fabrikation zur Verfügung gestellt werden, um dann weiter produziert zu werden. Das Prinzip der verwendeten "Superstrate"-Solarzelle wird hier, unter Nutzung einer Dünnschichtsolarzelle zur Gewinnung der elektrischen Energie für die Wasserdissoziation, in einer elektrochemischen Zelle für die Wasserspaltung mittels Licht eingesetzt. In einer zweiten, hier nicht im einzelnen gezeigten Variante, kann die Solarzelle 11 auch mittels einer Schicht für Schicht zu bildenden photoelektrischen Schichtstruktur 1 gebildet werden, wobei anschließend --insbesondere ohne Verfahrensunterbrechung-- die Koppelschicht 13 und die elektrochemische Schichtstruktur 2 aufgebracht wird.

Die Tandemsolarzelle 11 ist hier als Dünnschichtsolarzelle ausgebildet. Vorliegend eignet sich eine a-Si/µc-Si-basierende Tandem-Solarzelle als "Superstrate"-Solarzelle. Darüber hinaus zeigt sich, dass die p- und n-Schichten der Top- und Bottom-Solarzelle 51, 52 --typischerweise etwa 1 bis 20 µm dick-- ein elektrisches Feld erzeugen, welches sich über die intrinsische Schicht (i-Schicht) erstreckt und zu einer effizienten Sammlung der in der i-Schicht absorbierten Ladungsträger führt. Durch die Verwendung von zwei Absorber-Materialien mit unterschiedlicher Energielücke wird das Sonnenspektrum selektiv genutzt, d. h. mit hochenergetischen Lichtanteilen 3.1 und niederenergetischen Lichtanteilen 3.2; insgesamt wird die Photonenausbeute damit erhöht. Die Photospannung der gesamten Solarzelle 11 liegt über den maximal erreichbaren Photospannungen der Teilzellen. Damit ist es möglich, die für die Wasserspaltung benötigte Spannung von Voc -1.4 V zu erzeugen. Da in einem solchen Schichtsystem Thermalisierungsverluste reduziert werden, haben Multispektralzellen einen höheren theoretischen Wirkungsgrad. Als Basismaterial der pin oder nip-Schicht, dient vorliegend a-Si und µc-Si mit einer Bandlücke von etwa 1.8 bzw. 1.1 eV. Das Licht fällt also durch ein Substrat 31 aus Glas in die a-Si Top-Zelle 51 ein, die eine Schichtdicke von einigen 100 nm besitzt und den kurzwelligen Teil des Sonnenspektrums absorbiert. Die untere Bottom-Zelle 52, die das langwellige Licht absorbiert, hat eine Dicke von einigen Mikrometern. Den Frontseitenkontakt 32 des Bauelements bilden transparente leitfähige und Oxidschichten (engl. TCO), die in Kombination mit einem Silberfilm als hochreflektierender Rückkontakt genutzt werden. Dieses Konzept führt bislang zu Wirkungsgraden von 9 bis 10 % für industriell gefertigte Zellen und ggf. bis sogar 14 % für Zellen aus der Forschung. Der hochreflektierende Rückkontakt als Silberfilm ist vorliegend nicht separat eingezeichnet, da die Rückstreuung nicht absorbierter Photonen mittels der leitfähigen als Passivierungsschicht gebildeten Koppelschicht 13 umgesetzt werden kann. Grundsätzlich können auch andere Passivierungsschichten auf Aluminiumbasis oder Edelstahlbasis zur Verfügung gestellt werden, die für eine ausreichende Rückreflektion unter geeigneten Wachstumsbedingungen optimiert oder zusätzlich nachbearbeitet sind. Es kann auch eine separate Rückreflektionsschicht wie die hier genannte Silberschicht aufgebracht sein.

Die a-Si und µc-Si-Strukturen können durch PECVD oder Hot-Wire PVD -Verfahren bei Temperaturen von 100 bis 300 °C abgeschieden werden und erlauben damit die Nutzung preiswerter Substrate wie zum Beispiel Glas für das Substrat 31. Darüber hinaus werden die Solarzellen in pin- oder nip-Stapelfolgen hergestellt, um die Ladungsträgersammlung zu verbessern. Des Weiteren lassen sich Solarzellen mit unterschiedlicher spektraler Empfindlichkeit zu Tandem- oder Tripel-Zellen kombinieren. Soweit eine Passivierung an der Rückseite der Solarzelle 11, d. h. an der Endschicht der Bottom-Solarzelle 52, wie in Fig. 2 dargestellt noch nicht erfolgte, kann ein Silberrückkontakt als Passivierungsschicht genutzt oder die Passivierungsschicht als Koppelschicht 13 in einem zweiten Verfahrensschritt S2 aufgebracht werden. Dies kann durch eine einfache Metalldeposition erfolgen. Dazu reicht eine Passivierungsschicht mit einer Dicke von wenigen Nanometern, ggfs. auch schon bereits im Bereich zwischen 10nm und 50 nm. In einem dritten Schritt S3 wird eine Kathode --nämlich in einem ersten Vorgang S3.1 die eigentlich massive Elektrode 21, in einem zweiten Schritt S3.2 die poröse Funktionsschicht 23 und einem dritten Schritt S3.3 der Katalysator 25-- in chemischen Depositionsschritten aufgebracht. In einem vierten Schritt S4 wird eine Ionen-Austauschschicht 61 appliziert. Dies kann beispielsweise eine geeignete Ionen-Austauschmembran, eine Fritte, ein Vlies, eine basische PEM oder dergleichen geeignetes Ionen-Austauschmaterial sein. In einem fünften Verfahrensschritt S5 kann zunächst direkt die poröse Funktionsschicht 24 auf die Ionen-Austauschschicht 61 aufgebracht werden und anschließend die massive Rückelektrode 22.

Es kann auch zunächst in einem separaten, hier nicht gezeigten Prozess, die Kombination aus Rückelektrode 22 und Funktionsschicht 24 zur Verfügung gestellt werden, um dann als Einheit auf der Austauschschicht appliziert zu werden. Die Wahl einer Variante hängt von der Dicke und vom Material der Rückelektrode ab. Es hat sich gezeigt, dass sowohl die eine als auch die andere Variante möglich ist. Insbesondere kann der hier dargestellte direkte Prozess durch Aufbringung der Funktionsschicht im ersten Schritt S5.1 und anschließend der Aufbringung der massiven Elektrode im zweiten Schritt S5.2 erfolgen, ohne dass die Wasserstoffproduktion beeinträchtig wäre. In einem sechsten Schritt S6 wird schließlich das Containment für den Elektrolyten 10, hier beispielhaft die schon genannte, nicht erfindungsgemäße wässrige 0.1 M H₂SO₄ Lösung angebracht.

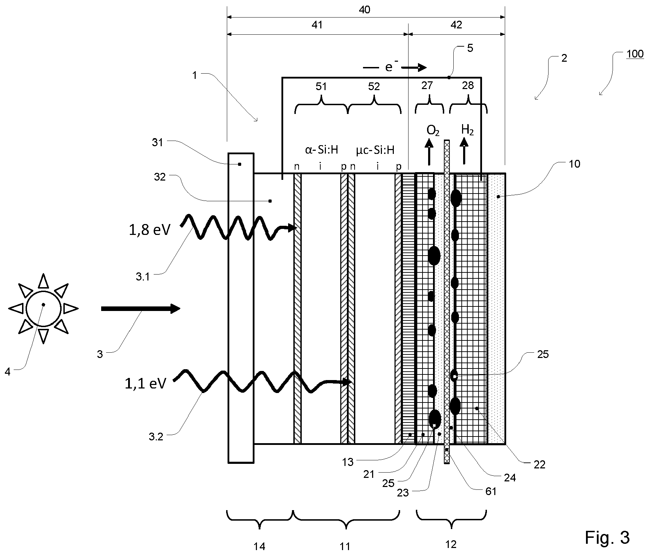

Figur 3 zeigt eine Variante der in Figur 2 gezeigten Zelle, bei denen im vorderen Elektrodenraum 27 Sauerstoff und im hinteren Elektrodenraum 28 Wasserstoff anfällt. Die pin-Strukturschichten der Solarzellen 51 und 52 sind entsprechend umgekehrt und der Stromfluss über die äußere Leiterbahn 5 erfolgt in die andere Richtung.

### Bezugszeichenliste

- 1: photoelektrische Schichtstruktur
- 2: elektrochemische Schichtstruktur
- 3: Licht
- 3.1: hochenergetische Lichtanteile
- 3.2: niedrigenergetischer Lichtanteile
- 4: Lichtquelle
- 5: externe Leiterbahn
- 10: Elektrolyt, insbesondere Wasser
- 11: Solarzelle
- 12: elektrochemischer Reaktor
- 13: Koppelschicht
- 14: Frontschichtstapel
- 21: Vorderelektrode
- 22: Rückelektrode
- 23: erste Funktionsschicht
- 24: zweite Funktionsschicht
- 25: Katalysator
- 27: vorderer Elektrodenraum
- 28: hinterer Elektrodenraum
- 31: Substrat
- 32: Frontseitenkontakt
- 40: Schichtaufbau
- 41: Vorderseite
- 42: Rückseite
- 51: Top-Solarzelle
- 51 p, 51 i, 51 n: Strukturschichten
- 52: Bottom-Solarzelle
- 52p, 52i, 52n: Strukturschichten
- 61: Ionen-Austauschschicht
- 100: Photoelektrochemische Zelle, PEC
- S1, S2, S3, S3.2, S3.3, S4, S5, S5.1, S5.2, S6: Verfahrensschritte

## Patentansprüche

1. Photoelektrochemische Zelle (100) zur lichtgetriebenen Erzeugung von Wasserstoff und Sauerstoff, insbesondere aus Wasser oder einem anderen auf wässriger Lösung basierenden Elektrolyten, mit einer photoelektrischen Schichtstruktur (1) und einer elektrochemischen Schichtstruktur (2) in einem Schichtaufbau (40), wobei
- die photoelektrische Schichtstruktur (1) zur vom Elektrolyten (10) unbeeinflussten Absorption von Licht (3) eine Vorderseite (41) des Schichtaufbaus (40) ausbildet, und
- die elektrochemische Schichtstruktur (2) zur Aufnahme des Elektrolyten (10) eine Rückseite (42) des Schichtaufbaus (40) ausbildet, und
- eine leitfähige und korrosionshemmende Koppelschicht (13) die photoelektrische Schichtstruktur (1) und die elektrochemische Schichtstruktur (2) miteinander im Schichtaufbau (40) elektrisch kontaktiert, wobei
- die elektrochemische Schichtstruktur (2) eine Elektrodenstruktur einer Vorderelektrode (21) und eine Elektrodenstruktur einer Rückelektrode (22) aufweist, zwischen denen eine IonenAustauschschicht (61) derart angeordnet ist, dass unter Bildung eines integrierten Schichtaufbaus (40) die Ionen-Austauschschicht (61) in Kontakt mit der zur Umsetzung des Elektrolyten (10) ausgebildeten Elektrodenstruktur der Vorderelektrode (21) und/oder der Elektrodenstruktur der Rückelektrode (22) ist,
- wobei die Elektrodenstruktur der Vorderelektrode (21) und/oder die Elektrodenstruktur der Rückelektrode (22) eine zur Umsetzung des Elektrolyten (10) vorgesehene Funktionsschicht (23), (24) aufweist, die als separate Schicht auf einem massiven Teil der Vorderelektrode (21) und/oder auf einem massiven Teil der Rückelektrode (22) aufgebracht ist,
- wobei die erste und/oder zweite Funktionsschicht (23, 24) eine die Umsetzung des Wassers im Elektrolyten (10) an der Vorderelektrode (21) und/oder Rückelektrode (22) katalytische Funktionalität aufweist, nämlich einen Katalysator trägt,
- wobei eine Aktivkomponente des Katalysators basiert auf Elementen ausgewählt aus der Gruppe umfassend: Ti, V, Cr, Mo, W, Mn, Fe, Ru, Co, Ni, Cu oder Zn,
- und wobei der Elektrolyt eine basische wässrige Lösung mit einem pH-Wert zwischen 7.1 und 14 umfasst.

2. Photoelektrochemische Zelle (100) nach Anspruch 1 **dadurch gekennzeichnet, dass** die photoelektrische Schichtstruktur (1) und die elektrochemische Schichtstruktur (2) als eine Sequenz von in Aufbaurichtung einzeln aufgebrachten Schichten einer einzigen Schichtabfolge in dem Schichtaufbau (40) integriert sind.

3. Photoelektrochemische Zelle (100) nach Anspruch 1 oder 2 **dadurch gekennzeichnet, dass** die photoelektrische Schichtstruktur (1) modular in Form einer Photovoltaikzelle und/oder die elektrochemische Schichtstruktur (2) modular in Form einer Elektrochemiezelle zur Verfügung gestellt und mittels der leitfähigen und korrosionshemmenden Koppelschicht (13) in dem Schichtaufbau (40) assembliert sind.

4. Photoelektrochemische Zelle (100) nach einem der Ansprüche 1 bis 3 **dadurch gekennzeichnet, dass** eine erste Funktionsschicht (23) auf der Vorderelektrode (21) in Kontakt mit der IonenAustauschschicht (61) ist und/oder eine zweite Funktionsschicht (24) auf der Rückelektrode (22) in Kontakt mit der Ionen-Austauschschicht (61) ist, insbesondere eine Funktionsschicht (23) elektrisch leitfähig und durchlässig für Produktgase ist.

5. Photoelektrochemische Zelle (100) nach einem der Ansprüche 1 bis 4 **dadurch gekennzeichnet, dass** ein Kontakt der Ionen-Austauschschicht (61) mit einer zur Umsetzung des Wassers in Elektrolyten (10) vorgesehenen Funktionsschicht (23, 24) ein wenigstens bereichsweise sich über den Querschnitt der Funktionsschicht (23, 24) erstreckender direkter Kontakt ist, insbesondere der Kontakt eine regelmäßige und/oder unregelmäßig Anordnung von Kontaktstellen aufweist, die sich über den Querschnitt der Funktionsschicht (23, 24) verteilen.

6. Photoelektrochemische Zelle (100) nach einem der Ansprüche 1 bis 5 **dadurch gekennzeichnet, dass** die erste und/oder zweite Funktionsschicht (23, 24) eine für die Vorderelektrode und/oder Rückelektrode oberflächenvergrößernde Funktionalität aufweist, insbesondere die erste und/oder zweite Funktionsschicht (23, 24) Poren, Öffnungen oder dgl. Aufnahmebereiche für den Elektrolyten (10) aufweist.

7. Photoelektrochemische Zelle (100) nach einem der Ansprüche 1 bis 6 **dadurch gekennzeichnet, dass** ein von der Elektrodenstruktur der Vorder- (21) und/oder Rückelektrode (22) getragener Katalysator als eine partikuläre und/oder immobilisierte molekulare Form und/oder massive und/oder poröse Schichten gebildet ist, insbesondere der Katalysator eine oder mehrere Aktivkomponenten und ein Trägermaterial aufweist.

8. Photoelektrochemische Zelle (100) nach einem der Ansprüche 1 bis 7 **dadurch gekennzeichnet, dass** ein Trägermaterial eines von der Elektrodenstruktur der Vorder- (21) und/oder Rückelektrode (22) getragenen Katalysators Materialien basierend auf Elementen oder Elementverbindungen der II. bis IV. Hauptgruppe und/oder der Nebengruppe IVb gebildet ist, insbesondere basierend auf Kohlenstoffmaterialien und/oder basierend auf Oxiden oder Mischoxiden von einem oder mehreren Elementen ausgewählt aus der Gruppe umfassend: Al, Si, Ti, Zr gebildet ist, insbesondere eine zur Umsetzung des Wassers im Elektrolyten (10) vorgesehene Funktionsschicht (23), (24) auf Kohlenstoff oder Graphit basiert.

9. Photoelektrochemische Zelle (100) nach einem der Ansprüche 1 bis 8 **dadurch gekennzeichnet, dass** der Elektrolyt eine Alkali- oder Erdalkalimetallhydroxidlauge umfasst, vorzugsweise Natronlauge, Kalilauge oder Kalkwasser.

10. Photoelektrochemische Zelle (100) nach einem der Ansprüche 1 bis 9 **dadurch gekennzeichnet, dass** die Ionenaustauschschicht (61) eine basische Polymerelektrolytmembran (PEM) aufweist, insbesondere eine Polymerelektrolytmembran (PEM) mit einer erhöhten Ionenbeweglichkeit und/oder Gasdichtigkeit gegenüber Wasserstoff und Sauerstoff.

11. Photoelektrochemische Zelle (100) nach einem der Ansprüche 1 bis 10 **dadurch gekennzeichnet, dass** die photoelektrische Schichtstruktur (1) als Dünnschicht-Solarzelle auf einem lichtdurchlässigen und/oder zumindest teilweise leitfähigen Front-Schichtstapel (14) aufgebracht ist, wobei insbesondere eine Texturierung des Substrats (31) und/oder Front-Schichtstapels (14) vorgesehen ist.

12. Photoelektrochemische Zelle (100) nach einem der Ansprüche 1 bis 11 **dadurch gekennzeichnet, dass** ein lichtdurchlässiger und leitfähiger Front-Schichtstapel (14) eine optisch transparente leitende Schicht, wie ITO (Indiumzinnoxid), AZO (Aluminium dotiertes Zinkoxid), FTO (Fluor dotiertes Zinnoxid) oder ein anderes ZnO oder TCO (transparente leitfähige Oxidschicht) od. dgl. Schicht aufweist, insbesondere auf Glas, Polymethylmetacrylaten (z. B. Plexiglas), Polycarbonaten, Polyethylentherephthalat, Polyacrylaten, Polyolefine oder einem transparenten polymerbasierten Substrat auf Basis eines leitenden Polymers (ICP) oder Gemischen daraus als transparentes Substrat (31).

13. Photoelektrochemische Zelle (100) nach einem der Ansprüche 1 bis 12 **dadurch gekennzeichnet, dass** die leitfähige und korrosionshemmende Koppelschicht direkt zwischen einer Strukturschicht, insbesondere einer n- oder p-dotierten Strukturschicht einer pin- oder nip-Struktur, einer Solarzelle (11), insbesondere einer Bottom-Solarzelle (52), und einer Vorderelektrode (21) eines elektrochemischen Reaktors (12) aufgebracht ist.

14. Photoelektrochemische Zelle (100) nach einem der Ansprüche 1 bis 13 **dadurch gekennzeichnet, dass** die leitfähige und korrosionshemmende Koppelschicht in Form einer Passivierungsschicht ausgeführt ist und/oder als leitfähige Schicht aufgebracht ist, insbesondere basierend auf Graphit, Silber oder Edelstahl oder anderen elektrolyt-resistenten Metallen, sowie leitfähigen Metalloxiden bzw. Mischmetalloxiden oder Metallnitriden und/oder deren Legierungen ausgeführt ist.

15. Photoelektrochemische Zelle (100) nach einem der Ansprüche 1 bis 14 **dadurch gekennzeichnet, dass** die photoelektrische Schichtstruktur (1) eine Multi-Junction-Solarzelle, wie eine Tandem- oder Tripel-Solarzelle, bildet, insbesondere eine oder mehrere ihrer Junctions mittels einer pin- oder nip-Struktur gebildet sind.

16. Photoelektrochemische Zelle (100) nach einem der Ansprüche 1 bis 15 **dadurch gekennzeichnet, dass** eine Solarzelle (11) auf Si-Basis und/oder SiGe-Basis gebildet ist und/oder auf Basis eines III-V-Halbleiters --wie einem GaAs, AlGaAs oder GalnP-System-- gebildet ist, insbesondere eine Top-Solarzelle (51) mit amorphem Halbleitermaterial und eine Bottom-Solarzelle (52) mit mikrokristallinem Halbleitermaterial, vorzugsweise Si und/oder SiGe, insbesondere zur Darstellung einer Tandem- oder Tripel-Solarzelle.

17. Photoelektrochemische Zelle (100) nach einem der Ansprüche 1 bis 16 **dadurch gekennzeichnet, dass** die photoelektrische Schichtstruktur (1) eine Single-Junction-Solarzelle, insbesondere auf Basis eines Halbleitermaterials mit einer Bandlücke oberhalb der von Si und GaAs bildet, insbesondere auf Basis von Gruppe III-V, II-VI oder IV-IV Halbleiterverbindungen, vorzugsweise auf Basis von GaP, ZnTe, CdSe, CdS oder SiC gebildet ist.

18. System mit einer Vielzahl von photoelektrochemischen Zellen (100) nach einem der Ansprüche 1 bis 17, wobei ein erster und/oder zweiter Reaktionsraum einer photo-elektrochemischen Zelle (100) mit einem entsprechenden weiteren ersten und/oder zweiten Reaktionsraum einer weiteren photoelektrochemischen Zelle fluiddynamisch verbunden ist.

19. Verfahren zur lichtgetriebenen Erzeugung von Wasserstoff und Sauerstoff, aus einem auf wässriger Lösung basierenden Elektrolyten, mit einer photoelektrochemischen Zelle (100), nach einem der Ansprüche 1 bis 17, mit einer photoelektrischen Schichtstruktur (1) und einer elektrochemischen Schichtstruktur (2), in einem Schichtaufbau (40), wobei
- Licht in der photoelektrischen Schichtstruktur (1) auf einer Vorderseite des Schichtaufbaus unbeeinflusst von einem Elektrolyten (10) absorbiert wird unter Erzeugung einer elektrischen Spannung,
- die elektrochemische Schichtstruktur (2) auf einer Rückseite des Schichtaufbaus den_Elektrolyten aufnimmt, und
- die photoelektrische Schichtstruktur (1) und die elektrochemische Schichtstruktur (2) über eine leitfähige und korrosionshemmende Koppelschicht im Schichtaufbau miteinander elektrisch kontaktiert werden, wobei
- die elektrische Spannung an die elektrochemische Schichtstruktur (2) über eine Elektrodenstruktur einer Vorderelektrode (21) und einer Elektrodenstruktur einer Rückelektrode (22) angelegt wird, zwischen denen eine Ionen-Austauschschicht im Schichtaufbau angeordnet ist, wobei
- der Elektrolyt (10) durch eine Ionen-Austauschschicht an der Elektrodenstruktur der Vorderelektrode (21) und/oder Elektrodenstruktur der Rückelektrode (22) umgesetzt wird, wobei in dem als integriertem Schichtaufbau gebildeten Schichtaufbau die Elektrodenstruktur der Vorderelektrode (21) und/oder Elektrodenstruktur der Rückelektrode (22) in Kontakt mit der Ionen-Austauschschicht ist.

20. Verfahren zur Herstellung einer photoelektrochemischen Zelle (100), nach einem der Ansprüche 1 bis 17, zur lichtgetriebenen Erzeugung von Wasserstoff und Sauerstoff, aus einem auf wässriger Lösung basierenden Elektrolyten, wobei eine photoelektrische Schichtstruktur (1) und eine elektrochemische Schichtstruktur (2), in einem Schichtaufbau integriert werden, wobei
- die photoelektrische Schichtstruktur (1) unter Bildung einer Vorderseite des Schichtaufbaus (40) zur vom Elektrolyten (10) unbeeinflussten Absorption von Licht (3) angeordnet wird, und
- die elektrochemische Schichtstruktur (2) unter Bildung einer Rückseite des Schichtaufbaus (40) und zur Aufnahme eines Elektrolyten (10) ausgebildet wird, wobei
- die photoelektrische Schichtstruktur (1) und die elektrochemische Schichtstruktur (2) über eine leitfähige und korrosionshemmende Koppelschicht im Schichtaufbau elektrisch miteinander kontaktiert werden, und
- die elektrochemische Schichtstruktur (2) eine Elektrodenstruktur einer Vorderelektrode (21) und eine Elektrodenstruktur einer Rückelektrode (22) aufweist, zwischen denen eine Ionen-Austauschschicht im Schichtaufbau angeordnet wird, wobei unter Bildung eines integrierten Schichtaufbaus (40) die Ionen-Austauschschicht in Kontakt mit einer zur Umsetzung des Wassers im Elektrolyten (10) vorgesehenen Elektrodenstruktur der Vorderelektrode (21) und/oder Elektrodenstruktur der Rückelektrode (22) angeordnet wird.

## Claims

1. Photoelectrochemical cell (100) for light-driven production of hydrogen and oxygen, especially from water or another electrolyte based on aqueous solution, having a photoelectric layer structure (1) and an electrochemical layer structure (2) in a layer assembly (40), wherein
- the photoelectric layer structure (1) for absorption of light (3) unaffected by the electrolyte (10) forms a front side (41) of layer assembly (40), and
- the electrochemical layer structure (2) for accommodation of the electrolyte (10) forms a back side (42) of the layer assembly (40), and
- a conductive and corrosion-inhibiting coupling layer (13) which electrically contacts the photoelectric layer structure (1) and the electrochemical layer structure (2) to one another in the layer assembly (40), wherein
- the electrochemical layer structure (2) has an electrode structure of a front electrode (21) and an electrode structure of a back electrode (22), between which an ion exchange layer (61) is arranged such that the ion exchange layer (61) is in contact with the electrode structure, designed for conversion of the electrolyte (10), of the front electrode (21) and/or with the electrode structure of the back electrode (22) to form an integrated layer assembly (40),
- wherein the electrode structure of the front electrode (21) and/or the electrode structure of the back electrode (22) has a functional layer (23), (24) which is provided for conversion of the electrolyte (10) and has been applied as a separate layer on a solid part of the front electrode (21) and/or on a solid part of the back electrode (22),
- wherein the first and/or second functional layer (23, 24) has a functionality which is catalytic for the conversion of the water in the electrolyte (10) at the front electrode (21) and/or back electrode (22), in that it bears a catalyst,
- wherein an active component of the catalyst is based on elements selected from the group comprising: Ti, V, Cr, Mo, W, Mn, Fe, Ru, Co, Ni, Cu or Zn,
- and wherein the electrolyte comprises a basic aqueous solution having a pH between 7.1 and 14.

2. Photoelectrochemical cell (100) according to Claim 1, **characterized in that** the photoelectric layer structure (1) and the electrochemical layer structure (2) are integrated as a sequence of layers applied individually in assembly direction in a single layer sequence in the layer assembly (40).

3. Photoelectrochemical cell (100) according to Claim 1 or 2, **characterized in that** the photoelectric layer structure (1) is provided in modular form, in the form of a photovoltaic cell, and/or the electrochemical layer structure (2) is provided in modular form, in the form of an electrochemical cell, and these are assembled by means of the conductive and corrosion-inhibiting coupling layer (13) in the layer assembly (40).

4. Photoelectrochemical cell (100) according to any of Claims 1 to 3, **characterized in that** a first functional layer (23) on the front electrode (21) is in contact with the ion exchange layer (61) and/or a second functional layer (24) on the back electrode (22) is in contact with the ion exchange layer (61), especially a functional layer (23) which is electrically conductive and permeable to product gases.

5. Photoelectrochemical cell (100) according to any of Claims 1 to 4, **characterized in that** a contact of the ion exchange layer (61) with a functional layer (23, 24) provided for conversion of the water in the electrolyte (10) is a direct contact which extends at least in regions over the cross section of the functional layer (23, 24), and the contact especially has a regular and/or irregular arrangement of contact sites distributed over the cross section of the functional layer (23, 24).

6. Photoelectrochemical cell (100) according to any of Claims 1 to 5, **characterized in that** the first and/or second functional layer (23, 24) has a surface area-increasing functionality for the front electrode and/or back electrode, and the first and/or second functional layer (23, 24) especially has pores, orifices or similar accommodation regions for the electrolyte (10).

7. Photoelectrochemical cell (100) according to any of Claims 1 to 6, **characterized in that** a catalyst supported by the electrode structure of the front electrode (21) and/or back electrode (22) takes the form of a particulate and/or immobilized molecular form and/or solid and/or porous layers, and the catalyst especially has one or more active components and a support material.

8. Photoelectrochemical cell (100) according to any of Claims 1 to 7, **characterized in that** a support material of a catalyst supported by the electrode structure of the front electrode (21) and/or back electrode (22) is formed materials on the basis of elements or element compounds of main groups II to IV and/or transition group IVb, especially on the basis of carbon materials and/or on the basis of oxides or mixed oxides of one or more elements selected from the group comprising: Al, Si, Ti, Zr, and a functional layer (23), (24) provided for conversion of the water in the electrolyte (10) is especially based on carbon or graphite.

9. Photoelectrochemical cell (100) according to any of Claims 1 to 8, **characterized in that** the electrolyte comprises an alkali metal or alkaline earth metal hydroxide solution, preferably sodium hydroxide solution, potassium hydroxide solution or calcium hydroxide solution.

10. Photoelectrochemical cell (100) according to any of Claims 1 to 9, **characterized in that** the ion exchange layer (61) has a basic polymer electrolyte membrane (PEM), especially a polymer electrolyte membrane (PEM) having elevated ion mobility and/or gas-tightness with respect to hydrogen and oxygen.

11. Photoelectrochemical cell (100) according to any of Claims 1 to 10, **characterized in that** the photoelectric layer structure (1) has been applied as a thin-film solar cell on a transparent and/or at least partly conductive front layer stack (14), especially with structuring of the substrate (31) and/or front layer stack (14).

12. Photoelectrochemical cell (100) according to any of Claims 1 to 11, **characterized in that** a transparent and conductive front layer stack (14) has an optically transparent conductive layer such as ITO (indium tin oxide), AZO (aluminium-doped zinc oxide), FTO (fluorine-doped tin oxide) or another ZnO or TCO (transparent conductive oxide layer) or similar layer, especially on glass, polymethyl methacrylates (e.g. Plexiglas), polycarbonates, polyethylene terephthalate, polyacrylates, polyolefins or a transparent polymer-based substrate based on a conductive polymer (ICP) or mixtures thereof as the transparent substrate (31).

13. Photoelectrochemical cell (100) according to any of Claims 1 to 12, **characterized in that** the conductive and corrosion-inhibiting coupling layer has been applied directly between a structural layer, especially an n- or p-doped structural layer of pin or nip structure, a solar cell (11), especially a bottom solar cell (52), and a front electrode (21) of an electrochemical reactor (12).

14. Photoelectrochemical cell (100) according to any of Claims 1 to 13, **characterized in that** the conductive and corrosion-inhibiting coupling layer takes the form of a passivating layer and/or has been applied as a conductive layer, especially based on graphite, silver or stainless steel or other electrolyte-resistant metals, and conductive metal oxides or mixed metal oxides or metal nitrides and/or alloys thereof.

15. Photoelectrochemical (100) according to any of Claims 1 to 14, **characterized in that** the photoelectric layer structure (1) forms a multi-junction solar cell such as a tandem or triple solar cell, and one or more of the junctions thereof are especially formed by means of a pin or nip structure.

16. Photoelectrochemical cell (100) according to any of Claims 1 to 15, **characterized in that** a solar cell (11) is formed on the basis of Si and/or on the basis of SiGe and/or on the basis of a III-V semiconductor - such as a GaAs, AlGaAs or GaInP system - especially a top solar cell (51) with amorphous semiconductor material and a bottom solar cell (52) with microcrystalline semiconductor material, preferably Si and/or SiGe, especially for production of a tandem or triple solar cell.

17. Photoelectrochemical cell (100) according to any of Claims 1 to 16, **characterized in that** the photoelectric layer structure (1) forms a single-junction solar cell, especially based on a semiconductor material having a band gap above that of Si and GaAs, especially formed based on group III-V, II-VI or IV-IV semiconductor compounds, preferably based on GaP, ZnTe, CdSe, CdS or SiC.

18. System having a multitude of photoelectrochemical cells (100) according to any of Claims 1 to 17, wherein a first and/or second reaction space of a photoelectrochemical cell (100) is connected by fluid-dynamic means to a corresponding further first and/or second reaction space of a further photoelectrochemical cell.

19. Process for light-driven production of hydrogen and oxygen, from an electrolyte based on aqueous solution, with a photoelectrochemical cell (100), according to any of Claims 1 to 17, having a photoelectric layer structure (1) and an electrochemical layer structure (2), in a layer assembly (40), wherein
- light is absorbed in the photoelectric layer structure (1) on a front side of the layer assembly, unaffected by an electrolyte (10), to generate an electrical voltage,
- the electrochemical layer structure (2) accommodates the electrolyte on a back side of the layer assembly, and
- the photoelectric layer structure (1) and the electrochemical layer structure (2) are electrically contacted to one another by means of a conductive and corrosion-inhibiting coupling layer in the layer assembly, wherein
- the electrical voltage is applied to the electrochemical layer structure (2) via an electrode structure of a front electrode (21) and an electrode structure of a back electrode (22), between which is arranged an ion exchange layer in the layer assembly, wherein
- the electrolyte (10) is converted by an ion exchange layer at the electrode structure of the front electrode (21) and/or electrode structure of the back electrode (22), wherein the electrode structure of the front electrode (21) and/or electrode structure of the back electrode (22) in the layer assembly formed as an integrated layer assembly is in contact with the ion exchange layer.

20. Process for producing a photoelectrochemical cell (100), according to any of Claims 1 to 17, for light-driven production of hydrogen and oxygen, from an electrolyte based on aqueous solution, wherein a photoelectric layer structure (1) and an electrochemical layer structure (2) are integrated in a layer assembly, wherein
- the photoelectric layer structure (1) is arranged to form a front side of the layer assembly (40) for absorption of light (3) unaffected by the electrolyte (10), and
- the electrochemical layer structure (2) is formed with formation of a back side of the layer assembly (40) and for accommodation of an electrolyte (10), wherein
- the photoelectric layer structure (1) and the electrochemical layer structure (2) are contacted with one another by means of a conductive and corrosion-inhibiting coupling layer in the layer assembly, and
- the electrochemical layer structure (2) has an electrode structure of a front electrode (21) and an electrode structure of a back electrode (22), between which is arranged an ion exchange layer in the layer assembly, with arrangement of the ion exchange layer in contact with an electrode structure, provided for conversion of the water in the electrolyte (10), of the front electrode (21) and/or electrode structure of the back electrode (22) to form an integrated layer assembly (40).

## Revendications

1. Pile photoélectrochimique (100) pour la production par la lumière d'hydrogène et d'oxygène, en particulier à partir d'eau ou à partir d'un autre électrolyte à base d'une solution aqueuse, à l'aide d'une structure photoélectrique à couches (1) et d'une structure électrochimique à couches (2) dans une construction à couches (40),
- la structure photoélectrique à couches (1) formant une face avant (41) de la construction à couches (40) pour l'absorption non influencée par l'électrolyte (10) de la lumière (3), et
- la structure électrochimique à couches (2) formant une face arrière (42) de la construction à couches (40) pour recevoir l'électrolyte (10), et
- une couche de couplage (13) conductrice et inhibitrice de corrosion mettant en contact électrique la structure photoélectrique à couches (1) et la structure électrochimique à couches (2) l'une avec l'autre dans la construction à couches (40),
- la structure électrochimique à couches (2) présentant une structure d'électrode d'une électrode avant (21) et une structure d'électrode d'une électrode arrière (22), entre lesquelles est disposée une couche d'échange d'ions (61) de manière telle que la couche d'échange d'ions (61), en formant une construction intégrée à couches (40), est en contact avec la structure d'électrode de l'électrode avant (21) et/ou la structure d'électrode de l'électrode arrière (22) conçue(s) pour la transformation de l'électrolyte (10),
- la structure d'électrode de l'électrode avant (21) et/ou la structure d'électrode de l'électrode arrière (22) présentant une couche fonctionnelle (23), (24) prévue pour la transformation de l'électrolyte (10), qui est appliquée comme couche séparée sur une partie massive de l'électrode avant (21) et/ou sur une partie massive de l'électrode arrière (22),
- la première et/ou deuxième couche fonctionnelle (23, 24) présentant une fonctionnalité catalytique pour la transformation de l'eau dans l'électrolyte (10) sur l'électrode avant (21) et/ou l'électrode arrière (22), c-à-d portant un catalyseur,
- un composant actif du catalyseur étant à base d'éléments choisis dans le groupe comprenant : Ti, V, Cr, Mo, W, Mn, Fe, Ru, Co, Ni, Cu ou Zn,
- et l'électrolyte comprenant une solution aqueuse basique, présentant un pH entre 7,1 et 14.

2. Pile photoélectrochimique (100) selon la revendication 1, **caractérisée en ce que** la structure photoélectrique à couches (1) et la structure électrochimique à couches (2) sont intégrées dans la construction à couches (40) en tant que séquence de couches appliquées individuellement dans le sens de la construction dans un ordre unique de couches,

3. Pile photoélectrochimique (100) selon la revendication 1 ou 2, **caractérisée en ce que** la structure photoélectrique à couches (1) est mise à disposition de manière modulaire, sous forme d'une pile photovoltaïque et/ou la structure électrochimique à couches (2) est mise à disposition de manière modulaire, sous forme d'une pile électrochimique et elles sont assemblées au moyen de la couche de couplage (13) conductrice et inhibitrice de corrosion dans la construction à couches (40).

4. Pile photoélectrochimique (100) selon l'une quelconque des revendications 1 à 3, **caractérisée en ce qu'**une première couche fonctionnelle (23) sur l'électrode avant (21) est en contact avec la couche d'échange d'ions (61) et/ou une deuxième couche fonctionnelle (24) sur l'électrode arrière (22) est en contact avec la couche d'échange d'ions (61), en particulier une couche fonctionnelle (23) est électriquement conductrice et perméable aux gaz produits.

5. Pile photoélectrochimique (100) selon l'une quelconque des revendications 1 à 4, **caractérisée en ce qu'**un contact de la couche d'échange d'ions (61) avec une couche fonctionnelle (23, 24) prévue pour la transformation de l'eau dans l'électrolyte (10) est un contact direct s'étendant au moins en partie sur la section transversale de la couche fonctionnelle (23, 24), en particulier le contact présente une disposition régulière et/ou irrégulière de sites de contact qui se répartissent sur la section transversale de la couche fonctionnelle (23, 24).

6. Pile photoélectrochimique (100) selon l'une quelconque des revendications 1 à 5, **caractérisée en ce que** la première et/ou deuxième couche fonctionnelle (23, 24) présente(nt) une fonctionnalité d'agrandissement de surface pour l'électrode avant et/ou l'électrode arrière, en particulier la première et/ou deuxième couche fonctionnelle (23, 24) présente(nt) des pores, des ouvertures ou des zones de réception analogues pour l'électrolyte (10).

7. Pile photoélectrochimique (100) selon l'une quelconque des revendications 1 à 6, **caractérisée en ce qu'**un catalyseur supporté par la structure d'électrode de l'électrode avant (21) et/ou de l'électrode arrière (22) est formé comme une forme moléculaire particulaire et/ou immobilisée et/ou des couches massives et/ou poreuses, en particulier le catalyseur présente un ou plusieurs composants actifs et un matériau support.

8. Pile photoélectrochimique (100) selon l'une quelconque des revendications 1 à 7, **caractérisée en ce qu'**un matériau support d'un catalyseur porté par la structure d'électrode de l'électrode avant (21) et/ou de l'électrode arrière (22) est formé matériaux à base d'éléments ou de composés d'éléments du IIème au IVème groupe principal et/ou du groupe secondaire IVb, en particulier formé à base de matériaux carbonés et/ou à base d'oxydes ou d'oxydes mixtes d'un ou de plusieurs éléments choisis dans le groupe comprenant : Al, Si, Ti, Zr, en particulier une couche fonctionnelle (23), (24) prévue pour la transformation de l'eau dans l'électrolyte (10) est/sont à base de carbone ou de graphite.

9. Pile photoélectrochimique (100) selon l'une quelconque des revendications 1 à 8, **caractérisée en ce que** l'électrolyte comprend une lessive d'hydroxyde de métal alcalin ou alcalino-terreux, de préférence de la lessive de soude caustique, de la potasse ou de l'eau de chaux.

10. Pile photoélectrochimique (100) selon l'une quelconque des revendications 1 à 9, **caractérisée en ce que** la couche d'échange d'ions (61) présente une membrane électrolytique polymère (PEM) basique, en particulier une membrane électrolytique polymère (PEM) présentant une mobilité augmentée des ions et/ou une imperméabilité aux gaz augmentée par rapport à l'hydrogène et à l'oxygène.

11. Pile photoélectrochimique (100) selon l'une quelconque des revendications 1 à 10, **caractérisée en ce que** la structure photoélectrique à couches (1) est appliquée sous forme de pile solaire en couche mince sur un empilement de couches frontal (14) transparent et/ou au moins partiellement conducteur, une texturation du substrat (31) et/ou de l'empilement de couches frontal (14) étant en particulier prévue.

12. Pile photoélectrochimique (100) selon l'une quelconque des revendications 1 à 11, **caractérisée en ce qu'**un empilement de couches frontal (14) transparent et conducteur présente une couche conductrice optiquement transparente telle qu'une couche en ITO (oxyde d'indium et d'étain), AZO (oxyde de zinc dopé à l'aluminium), FTO (oxyde d'étain dopé au fluor) ou une autre couche en ZnO ou en TCO (couche d'oxyde transparente conductrice) ou une couche analogue, en particulier sur du verre, des poly(méthacrylates de méthyle) (par exemple du plexiglas), des polycarbonates, du poly(téréphtalate d'éthylène), des polyacrylates, des polyoléfines ou un substrat transparent à base de polymère à base d'un polymère conducteur (ICP) ou des mélanges de ceux-ci comme substrat transparent (31).

13. Pile photoélectrochimique (100) selon l'une quelconque des revendications 1 à 12, **caractérisée en ce que** la couche de couplage conductrice et inhibitrice de corrosion est appliquée directement entre une couche de structure, en particulier une couche de structure dopée par n ou p d'une structure PIN ou NIP, d'une pile solaire (11), en particulier une pile solaire de fond (52), et une électrode avant (21) d'un réacteur électrochimique (12).

14. Pile photoélectrochimique (100) selon l'une quelconque des revendications 1 à 13, **caractérisée en ce que** la couche de couplage conductrice et inhibitrice de corrosion est réalisée sous forme d'une couche de passivation et/ou est appliquée sous forme de couche conductrice, en particulier est réalisée à base de graphite, d'argent ou d'acier noble ou d'autres métaux résistants aux électrolytes, ainsi que d'oxydes métalliques, d'oxydes métalliques mixtes ou de nitrures métalliques et/ou leurs alliages, conducteurs.

15. Pile photoélectrochimique (100) selon l'une quelconque des revendications 1 à 14, **caractérisée en ce que** la structure photoélectrique à couches (1) forme une pile solaire à jonctions multiples, telle qu'une pile solaire tandem ou triple, en particulier une ou plusieurs de ses jonctions sont formées au moyen d'une structure PIN ou NIP.

16. Pile photoélectrochimique (100) selon l'une quelconque des revendications 1 à 15, **caractérisée en ce qu'**une pile solaire (11) est formée à base de Si et/ou de SiGe et/ou à base d'un semi-conducteur III-V - comme un système GaAs, AlGaAs ou GaInP, en particulier une pile solaire du dessus (51) présentant un matériau semi-conducteur amorphe et une pile solaire de fond (52) présentant un matériau semi-conducteur microcristallin, de préférence Si et/ou SiGe, en particulier pour réaliser une pile solaire tandem ou triple.

17. Pile photoélectrochimique (100) selon l'une quelconque des revendications 1 à 16, **caractérisée en ce que** la structure photoélectrique à couches (1) forme une pile solaire à jonctions uniques, en particulier est formée à base d'un matériau semi-conducteur présentant une bande interdite supérieure à celle de Si et GaAs, en particulier à base de composés semi-conducteurs du groupe III-V, II-VI ou IV-IV, de préférence à base de GaP, ZnTe, CdSe, CdS ou SiC.

18. Système présentant une multitude de piles photoélectrochimiques (100) selon l'une quelconque des revendications 1 à 17, un premier et/ou deuxième espace de réaction d'une pile photoélectrochimique (100) étant relié(s) de manière fluidiquement dynamique avec un autre premier et/ou deuxième espace de réaction correspondant(s) d'une autre pile photoélectrochimique.

19. Procédé pour la production par la lumière d'hydrogène et d'oxygène, à partir d'un électrolyte à base d'une solution aqueuse, à l'aide d'une pile photoélectrochimique (100), selon l'une quelconque des revendications 1 à 17, présentant une structure photoélectrique à couches (1) et une structure électrochimique à couches (2), dans une construction à couches (40),
- de la lumière étant absorbée de manière non influencée par un électrolyte (10) dans la structure photoélectrique à couches (1) sur une face avant de la construction à couches avec production d'une tension électrique,
- la structure électrochimique à couches (2) recevant l'électrolyte sur une face arrière de la construction à couches, et
- la structure photoélectrique à couches (1) et la structure électrochimique à couches (2) étant mises en contact électrique l'une avec l'autre via une couche de couplage conductrice et inhibitrice de corrosion dans la construction à couches,
- la tension électrique étant appliquée sur la structure électrochimique à couches (2) via une structure d'électrode d'une électrode avant (21) et une structure d'électrode d'une électrode arrière (22), entre lesquelles est disposée une couche d'échange d'ions dans la construction à couches,
- l'électrolyte (10) étant transformé par une couche d'échange d'ions sur la structure d'électrode de l'électrode avant (21) et/ou la structure d'électrode de l'électrode arrière (22), la structure d'électrode de l'électrode avant (21) et/ou la structure d'électrode de l'électrode arrière (22) étant en contact avec la couche d'échange d'ions dans la construction à couches formée comme une construction intégrée à couches.

20. Procédé pour la fabrication d'une pile photoélectrochimique (100), selon l'une quelconque des revendications 1 à 17, pour la production par la lumière d'hydrogène et d'oxygène, à partir d'un électrolyte à base d'une solution aqueuse, une structure photoélectrique à couches (1) et une structure électrochimique à couches (2) étant intégrées dans une construction à couches,
- la structure photoélectrique à couches (1) étant disposée en formant une face avant de la construction à couches (40) pour l'absorption non influencée par l'électrolyte (10) de la lumière (3), et
- la structure électrochimique à couches (2) étant réalisée en formant une face arrière de la construction à couches (40) et pour recevoir un électrolyte (10),
- la structure photoélectrique à couches (1) et la structure électrochimique à couches (2) étant mises en contact électrique l'une avec l'autre via une couche de couplage conductrice et inhibitrice de corrosion dans la construction à couches, et
- la structure électrochimique à couches (2) présentant une structure d'électrode d'une électrode avant (21) et une structure d'électrode d'une électrode arrière (22), entre lesquelles est disposée une couche d'échange d'ions dans la construction à couches, la couche d'échange d'ions étant disposée, en formant une construction intégrée à couches (40), en contact avec la structure d'électrode de l'électrode avant (21) et/ou la structure d'électrode de l'électrode arrière (22) prévue(s) pour la transformation de l'eau dans l'électrolyte (10).
